(19) Europäisches Patentamt

European Patent Office

Office européen des brevets

(11) **EP 1 180 726 B1**

(12) **EUROPÄISCHE PATENTSCHRIFT**

(45) Veröffentlichungstag und Bekanntmachung des Hinweises auf die Patenterteilung:
**30.08.2006 Patentblatt 2006/35**

(51) Int Cl.:
***G03F 7/20*** (2006.01)

(21) Anmeldenummer: **01117712.8**

(22) Anmeldetag: **27.07.2001**

(54) **Beleuchtungssystem für die Mikrolithographie**

Illumination system for microlithography

Système d'illumination pour la microlithographie

(84) Benannte Vertragsstaaten:
**DE FR GB NL**

(30) Priorität: **18.08.2000 DE 10040898**

(43) Veröffentlichungstag der Anmeldung:
**20.02.2002 Patentblatt 2002/08**

(73) Patentinhaber: **Carl Zeiss SMT AG**
**73446 Oberkochen (DE)**

(72) Erfinder:
• **Köhler, Jess, Dr.**
**73447 Oberkochen (DE)**

• **Wangler, Johannes**
**89551 Königsbronn (DE)**

(74) Vertreter: **Müller-Rissmann, Werner Albrecht et al**
**Carl Zeiss,**
**Patentabteilung**
**73446 Oberkochen (DE)**

(56) Entgegenhaltungen:
**EP-A- 0 939 341    WO-A-01/61411**

• **PATENT ABSTRACTS OF JAPAN vol. 1999, no. 09, 30. Juli 1999 (1999-07-30) -& JP 11 121358 A (CANON INC), 30. April 1999 (1999-04-30) -& US 6 285 440 B1 4. September 2001 (2001-09-04)**

## Beschreibung

Die vorliegende Erfindung betrifft ein Beleuchtungssystem mit einem Wabenkondensor für eine Mikrolithographie-Projektionsbelichtungsanlage, eine Mikrolithographie-Projektionsbelichtungsanlage umfassend ein Beleuchtungssystem mit einem Wabenkondensor und ein Verfahren zur Herstellung von mikrostrukturierten Bauteilen mit einer Mikrolithographie-Projektionsbelichtungsanlage umfassend ein Beleuchtungssystem mit einem Wabenkondensor.

Aus der US 4,682,885 ist ein gattungsgemäßes Beleuchtungssystem bekannt. Das Licht einer Quecksilberdampf-Lampe wird von einem elliptischen Kollektorspiegel aufgenommen und auf einen optischen Integrator gerichtet, der als spezielle Ausführungsform eines Wabenkondensors ausgebildet ist. Der optische Integrator dient der Lichtmischung und der Erzeugung einer Vielzahl von Lichtbüscheln, die durch eine Kondensoroptik in einer Bildebene überlagert werden und dort ein rechteckförmiges Feld beleuchten. Der optische Integrator besteht dabei aus zwei Paaren von Platten mit Zylinderlinsen, wobei die Zylinderachsen der Zylinderlinsen eines Paares parallel, die Zylinderachsen der Paare zueinander senkrecht ausgerichtet sind. Die beiden Platten eines Paares sind in der gegenseitigen Brennebene der Zylinderlinsen angeordnet. Durch unterschiedlich große Brennweiten der beiden Paare wird in der Bildebene ein rechteckförmiges Feld mit einem Seiten-Aspektverhältnis größer 1:1 beleuchtet.

Aus US 5,926,257 ist ein Beleuchtungssystem mit einem Wabenkondensor bekannt, der einen ähnlichen Aufbau zu dem aus der US 4,682,885 bekannten Wabenkondensor aufweist. Die Zylinderlinsen sind dabei als diffraktive Elemente mit zylindrischer Wirkung ausgebildet.

Die US 5,963,305 beschreibt ebenfalls einen Wabenkondensor aus zwei senkrecht zueinander angeordneten Paaren von Platten mit Zylinderlinsen. Gezeigt werden refraktive und diffraktive Ausführungsformen der Zylinderlinsen.

Nachteilig an den in US 4,682,885, US 5,926,257 und US 5,963,305 gezeigten Wabenkondensoren ist die Tatsache, daß die auf den Wabenkondensor folgende Blendenebene des Beleuchtungssystems nur unvollständig ausgeleuchtet wird, wenn das auf den Wabenkondensor treffende Strahlenbüschel nur eine geringe Divergenz aufweist. Ein derartiges Strahlenbüschel, wie es beispielsweise von einer Laserlichtquelle erzeugt wird, wird durch die gekreuzten Zylinderlinsenplatten in eine Vielzahl von Strahlenbüscheln zerlegt, die in die Blendenebene des Beleuchtungssystems fokussiert werden und dort ein Gitter von sekundären Lichtquellen bilden. Die sekundären Lichtquellen sind aufgrund der geringen Divergenz des Strahlenbüschels am Eintritt des Wabenkondensors nur punktförmig. Die Blendenebene ist deshalb nur mit diskreten Intensitätspeaks ausgeleuchtet. Bei den Wabenkondensoren mit refraktiven Zylinderlinsen ist die Anzahl der ausgeleuchteten Zylinderlinsen in der Größenordnung von $10^1$. Deshalb befinden sich in der Blendenebene nur in der Größenordnung $10^2$ sekundäre Lichtquellen. Durch den Einsatz von diffraktiven Elementen mit zylindrischer Wirkung kann zwar die Anzahl der sekundären Lichtquellen auf Grund der geringeren Elementbreite erhöht werden, doch ergeben sich dann durch den sehr großen Abbildungsmaßstab zwischen diffraktiven Elementen und dem auszuleuchtenden Feld sehr hohe Anforderungen an die Qualität der diffraktiven Elemente, insbesondere an die Randschärfe.

Da die beiden Paare von Zylinderlinsenplatten in US 4,682,885, US 5,926,257 und US 5,963,305 unterschiedliche Brennweiten aufweisen und die in Lichtrichtung jeweils nachgeordnete Zylinderlinsenplatte eines Paares in der Nähe der Blendenebene angeordnet ist, sind die in Lichtrichtung jeweils vorgeordneten Zylinderlinsenplatten der beiden Paare axial getrennt angeordnet. Wird der Wabenkondensor mit einem Strahlenbüschel endlicher Divergenz beleuchtet, wie es beispielsweise von einer Quecksilberdampf-Lampe erzeugt wird, so führt die axiale Trennung der vorgeordneten Zylinderlinsenplatten zu einer elliptischen Ausleuchtung der Blendenebene. Da für den Einsatz in der Mikrolithographie die Ausleuchtung der Blendenebene möglichst rotationssymmetrisch sein sollte, ist der Einsatz von zusätzlichen Blenden oder Filtern erforderlich, wodurch ein Lichtverlust auftritt.

Aus US 5,847,746 ist ein Beleuchtungssystem bekannt, das zur Lichtmischung zwei gekreuzte Zylinderlinsenplatten unterschiedlicher Brennweite einsetzt. Die Zylinderlinsenplatten werden dabei mit einem parallelen Lichtbüschel geringer Divergenz beleuchtet. Um zu vermeiden, daß die Blendenebene eines nachfolgenden Projektionsobjektives mit Intensitätspeaks punktuell ausgeleuchtet wird, sind die Brennweiten der beiden Zylinderlinsenplatten so eingestellt, daß die sekundären Lichtquellen in meridionale und sagittale sekundäre Lichtquellen aufgespalten werden, die defokussiert angeordnet sind. Dadurch werden die Intensitätspeaks in der Blendenebene zu Strichen geringerer Maximalintensität auseinandergezogen. Nachteilig an dieser Anordnung ist die nur partielle Ausleuchtung der Blendenebene und die Tatsache, daß die in der Regel gewünschte Punktsymmetrie der Blendenausleuchtung durch die strichförmigen Intensitätspeaks verletzt wird.

Aus US 5,815,248 ist der Einsatz eines eindimensionalen Gitters vor einem Wabenkondensor bekannt. Der Wabenkondensor besteht nicht aus einzelnen Platten mit Zylinderlinsen, sondern aus einer Platte mit stabförmigen Linsenelementen, die in einem zweidimensionalen Array angeordnet sind. Bei einem zu beleuchtenden Feld mit hohem Seiten-Aspektverhältnis müssen die Linsenelemente ein gleich großes Seiten-Aspektverhältnis aufweisen. Dementsprechend sind die von den Linsenelementen in der Blendenebene erzeugten sekundären Lichtquellen ohne das eindimensionale Gitter ungleichmäßig verteilt. Mit Hilfe des eindimensionalen Gitters wird das Array mit Linsenelementen aus drei in einer Ebene liegenden Richtungen beleuchtet, so daß die Zahl der von dem Array erzeugten sekundären Lichtquellen erhöht wird. Dadurch kann eine gleichmäßigere Verteilung der sekundären Lichtquellen in der auf den Wabenkondensor folgenden Blendenebene erzielt werden. Nachteilig an der Verwendung eines eindimensionalen Gitters ist die Tatsache, daß die Ausleuchtung der Blendenebene aus diskreten Intensitätspeaks besteht und keine homogene Ausleuchtung erzielt wird. Zudem weisen die von den Linsenelementen erzeugten optischen Kanäle ein hohes Seiten-Aspektverhältnis auf, so daß ein Großteil der Lichtkanäle bei der üblichen kreisförmigen Beleuchtung des Wabenkondensors nur unvollständig beleuchtet wird.

Aus der DE 198 55 106 A1 der Anmelderin ist ein Beleuchtungssystem für die VUV-Mikrolithographie mit einem Wabenkondensor als optischem Integrator bekannt. Vor dem Wabenkondensor ist zur Divergenzerhöhung ein Mikrolinsenarray mit rechteckförmigen Einzellinsen angeordnet. Der Wabenkondensor besteht dabei aus zwei in der gegenseitigen Brennebene angeordneten Wabenplatten, die aus einem Array von Einzellinsen oder aus zwei gekreuzten Zylinderlinsenplatten gebildet werden. Die von den Einzellinsen, beziehungsweise den gekreuzten Zylinderlinsen, gebildeten optischen Kanäle weisen dabei ein ähnliches Seiten-Aspektverhältnis wie das auszuleuchtende Feld auf. Um die Blendenebene gleichmäßig beleuchten zu können, müssen die rechteckförmigen Mikrolinsen zur Divergenzerhöhung eine ähnliches Seiten-Aspektverhältnis wie die optischen Kanäle aufweisen. Nachteilig an dieser Anordnung ist, daß bei einem Feld mit einem hohen Seiten-Aspektverhältnis die Einzellinsen ebenfalls ein hohes Seiten-Aspektverhältnis aufweisen müssen. Derartige Einzellinsen sind aufwendig herzustellen. Verwendet man für die Wabenplatten gekreuzte Zylinderlinsenplatten, so ist die Breite der Zylinderlinsen für die beiden Ausrichtungen stark unterschiedlich, wenn die gekreuzten Zylinderlinsen gleiche Brennweite aufweisen. Für die Zylinderlinsenplatten unterschiedlicher Ausrichtung müssen unter Umständen verschiedene Herstellverfahren angewandt werden. Auch bei dieser Konfiguration wird ein Großteil der Lichtkanäle bei der üblichen kreisrunden Beleuchtung des Wabenkondensors nur unvollständig beleuchtet.

Ein weiteres Beleuchtungssystem mit einem Wabenkondensor aus zwei senkrecht zueinander angeordneten Paaren von Platten von Zylinderlinsen ist aus JP11121358 A bekannt. Gezeigt werden refraktive Ausführungsformen der Zylinderlinsen.

Aufgabe der vorliegenden Erfindung ist es deshalb, ein Beleuchtungssystem mit einem Wabenkondensor für eine Mikrolithographie-Projektionsbelichtungsanlage anzugeben, mit dem bei hoher Effizienz die Blendenebene möglichst vollständig und symmetrisch ausleuchtbar ist.

Diese Aufgabe wird durch ein Beleuchtungssystem mit den Merkmalen des Anspruchs 1 und Anspruchs 27 gelöst. Vorteilhafte Ausgestaltungen der Erfindung ergeben sich aus den Merkmalen der abhängigen Ansprüche.

In dem Beleuchtungssystem werden die von einer Lichtquelle ausgehenden Strahlen von einem ersten Objektiv aufgenommen und formen in der Austrittsebene des ersten Objektives ein Strahlenbündel, das vorzugsweise ein paralleles Strahlenbündel geringer Divergenz ist. Ein Wabenkondensor erzeugt aus dem Strahlenbündel eine Vielzahl von Strahlenbündeln, die durch eine Kondensoroptik in einer Bildebene des Beleuchtungssystems überlagert werden und dort vorzugsweise ein rechteckförmiges Feld ausleuchten. Die längere Feldseite ist in x-Richtung, die kürzere Feldseite in y-Richtung ausgerichtet. In der Bildebene des Beleuchtungssystems ist üblicherweise das Retikel für die Mikrolithographie-Projektionsbelichtungsanlage oder eine Maskiervorrichtung, die mit einem nachfolgenden Objektiv auf das Retikel abgebildet wird, angeordnet. Der Wabenkondensor weist mindestens eine erste und eine zweite Platte mit stabförmigen Zylinderlinsen auf, die senkrecht zur Richtung der Zylinderachsen der Zylinderlinsen aneinandergereiht sind. Die Zylinderlinsen haben vorzugsweise eine zylindrische Vorderfläche und eine plane Rückfläche. Die zylindrische Vorderfläche weist senkrecht zur Zylinderachse eine konvexen Querschnitt und parallel zur Zylinderachse einen planen Querschnitt auf. Die Zylinderachsen der Zylinderlinsen der beiden Platten sind vorzugsweise senkrecht zueinander ausgerichtet. Die Zylinderachsen der Zylinderlinsen der ersten Platte sind in x-Richtung ausgerichtet. Deshalb werden die Zylinderlinsen der ersten Platte im folgenden als y-Feldwaben bezeichnet. Die Zylinderachsen der Zylinderlinsen der zweiten Platte sind in y-Richtung ausgerichtet. Deshalb werden die Zylinderlinsen der zweiten Platte im folgenden als x-Feldwaben bezeichnet. Die y- und x-Feldwaben erzeugen in der auf den Wabenkondensor folgenden Blendenebene ein Gitter von sekundären Lichtquellen. Weist das auf den Wabenkondensor treffende Strahlenbündel eine geringe Divergenz der Strahlwinkel auf, so ist die Ausdehnung der sekundären Lichtquellen gering, und die Blendenebene ist ungleichmäßig mit diskreten Intensitätspeaks beleuchtet. Um eine gleichmäßige Ausleuchtung der Blendenebene zu erreichen, ist vorteilhafterweise in Lichtrichtung vor der Platte mit y-Feldwaben eine dritte Platte mit stabförmigen Zylinderlinsen und in Lichtrichtung vor der Platte mit x-Feldwaben eine vierte Platte mit stabförmigen Zylinderlinsen angeordnet. Die Zylinderlinsen der dritten Platte sind in Richtung der Zylinderachsen gleich lang wie die y-Feldwaben, weisen aber senkrecht zur Richtung der Zylinderachsen eine geringere Breite als die y-Feldwaben auf. Sie werden im folgenden als y-Mikrozylinderlinsen bezeichnet. Die Zylinderachsen der y-Mikrozylinderlinsen sind dabei parallel zu den Achsen der y-Feldwaben ausgerichtet. Die Zylinderlinsen der vierten Platte sind in Richtung der Zylinderachsen gleich lang wie die x-Feldwaben, weisen aber senkrecht zur Richtung der Zylinderachsen eine geringere Breite als die x-Feldwaben auf. Sie werden im folgenden als x-Mikrozylinderlinsen bezeichnet. Die Zylinderachsen der x-Mikrozylinderlinsen sind dabei parallel zu den Achsen der x-Feldwaben ausgerichtet. Die vor den Feldwaben angeordneten Mikrozylinderlinsen führen zu einer Divergenzerhöhung des auf die Feldwaben treffenden Strahlenbündels. Dadurch wird erreicht, daß die Ausdehnung der sekundären Lichtquellen in der Blendenebene erhöht und damit die Blendenebene gleichmäßiger ausgeleuchtet wird. Der Vorteil des Einsatzes von zwei vor den jeweiligen Feldwaben angeordneten Platten mit Mikrozylinderlinsen besteht darin, daß die Divergenzerhöhung jeweils unmittelbar vor den Feldwaben und nur in einer Ebene erfolgt. Die Flächennormale dieser Ebene zeigt dabei in Richtung der Zylinderachsen der Mikrozylinderlinsen und der entsprechenden Feldwaben. Die Mikrozylinderlinsen sind dabei refraktiv oder diffraktiv ausgebildet.

Es ist vorteilhaft, wenn die x- und y-Feldwaben ähnliche Breiten senkrecht zu den jeweiligen Zylinderachsen aufweisen. Vorzugsweise sind die Breiten der x- und y-Feldwaben im Rahmen der Fertigungstoleranzen gleich groß. Dadurch läßt sich das gleiche Fertigungsverfahren für x- und y-Feldwaben anwenden. Ein weiterer Vorteil von gleich breiten x- und y-Feldwaben besteht darin, daß die sekundären Lichtquellen in der Blendenebene auf einem quadratischen Gitter zum Liegen kommen. Um bei ähnlichen Breiten für die x- und y-Feldwaben ein rechteckförmiges Feld auszuleuchten, müssen die x- und y-Feldwaben unterschiedliche Brennweiten aufweisen. Da es sich bei den Feldwaben um Zylinderlinsen handelt, bezieht sich die Angabe einer Brennweite für die Feldwaben auf den Flächenschnitt, in dem die Feldwaben eine optische Wirkung aufweisen. Da die kürzere Feldseite in der Bildebene des Beleuchtungssystems in y-Richtung zeigt, muß die Brennweite der y-Feldwaben größer als die Brennweite der x-Feldwaben sein, vorzugsweise größer als das 1.5-fache, besonders bevorzugt größer als das 2-fache.

Vorzugsweise sollte die Winkelverteilung der auf die Feldwaben treffenden Strahlen an jedem Ort der Feldwaben homogen sein. Da die Mikrozylinderlinsen diskrete Elemente sind, ist dies nicht möglich. Um jedoch die Feldwaben mit einer möglichst ortsunabhängigen Winkelverteilung zu beleuchten, ist es von Vorteil, wenn die Breite der Mikrozylinderlinsen kleiner als die Breite der entsprechenden Feldwaben ist. Vorteilhafterweise beträgt die Breite der Mikrozylinderlinsen weniger als die Hälfte, bevorzugt weniger als 1/5 der Breite der entsprechenden Feldwaben.

Die von den Feldwaben in der Blendenebene erzeugten sekundären Lichtquellen sind nicht homogen ausgeleuchtet, sondern weisen auf Grund der Rasterung der Mikrozylinderlinsen Intensitätsschwankungen auf. Die Zahl der Intensitätspeaks innerhalb einer sekundären Lichtquelle in einer Richtung entspricht dabei der Zahl der Mikrozylinderlinsen pro Feldwabe. Ist die Zahl der x-Mikrozylinderlinsen pro x-Feldwabe und die Zahl der y-Mikrozylinderlinsen pro y-Feldwabe gleich groß, so weisen die sekundären Lichtquellen in x- und y-Richtung gleich viele Intensitätspeaks auf.

Die Ausdehnung der sekundären Lichtquellen in der Blendenebene ist durch den maximalen Winkel bezüglich der optischen Achse der auf die Feldwaben treffenden Strahlen und durch den Abstand der Feldwaben von der Blendenebene bestimmt, der nahezu der Brennweite der Feldwaben entspricht. Der maximale Winkel wiederum ist durch Breite und Brennweite der Mikrozylinderlinsen festgelegt. Die Brennweite der Mikrozylinderlinsen bezieht sich auf den Flächenschnitt, in dem die Mikrozylinderlinsen eine optische Wirkung aufweisen. Damit sich die einzelnen sekundären Lichtquellen, deren Abstand in der Blendenebene der Breite der Feldwaben entspricht, nicht überschneiden, muß der maximale Winkel nach oben begrenzt werden. Vorteilhafterweise wird deshalb das Verhältnis von Breite und Brennweite der Mikrozylinderlinsen kleiner als das Verhältnis von Breite und Brennweite der entsprechenden Feldwaben gewählt.

Andererseits soll die Blendenebene möglichst homogen ausgeleuchtet sein. Deshalb sollte der maximale Winkel der auf die Feldwabe treffenden Strahlen bezüglich der optischen Achse eine Mindestwert aufweisen. Es ist vorteilhaft, wenn die Ausdehnung der sekundären Lichtquellen mindestens dem halben Abstand der sekundären Lichtquellen entspricht. Dies ist dann der Fall, wenn das Verhältnis von Breite und Brennweite der Mikrozylinderlinsen mindestens die Hälfte des Verhältnisses von Breite und Brennweite der entsprechenden Feldwaben beträgt.

Da an jeder Grenzfläche zwischen Materialien unterschiedlicher Brechzahl Reflexionsverluste auftreten, sollte die Zahl der Grenzflächen so gering wie möglich gehalten werden. Gerade bei Wellenlängen unter 200 nm ist es ein Ziel, die Zahl der optischen Elemente so gering wie möglich zu halten. Es ist deshalb besonders vorteilhaft, die Platte mit den y-Mikrozylinderlinsen und die Platte mit den entsprechenden y-Feldwaben und/oder die Platte mit den x-Mikrozylinderlinsen und die Platte mit den entsprechenden x-Feldwaben jeweils zu einer auf Vorder- und Rückfläche strukturierten Platte zu vereinigen, beispielsweise durch Ansprengen oder über eine Kittfläche. Ebenso ist die gleichzeitige Strukturierung von Vorder- und Rückfläche einer Platte möglich. Dadurch lassen sich für jede einteilig aufgebaute Mikrozylinderlinsen-Feldwaben-Platte zwei Grenzflächen einsparen.

Es ist vorteilhaft, wenn die Blendenebene frei zugänglich ist, um in der Blendenebene Blendeneinrichtungen oder Kontrolleinrichtungen für Meßzwecke zu installieren. Der freie Arbeitsabstand sollte in Lichtrichtung vor der Blendenebene mindestens 1.0 mm, bevorzugt mindestens 1.5 mm betragen. Nach der Blendenebene sollte der freie Arbeitsabstand mindestens 1 mm, bevorzugt 3 mm betragen.

Mit den Blendeneinrichtungen in der Blendenebene ist die Ausleuchtung der Blendenebene und damit auch die Pupillenausleuchtung steuerbar. Übliche Blendeneinrichtungen haben eine kreisrunde Öffnung für eine sogenannte konventionelle Pupillenausleuchtung oder zwei beziehungsweise vier punktsymmetrisch zur Blendenmitte angeordnete Öffnungen für eine sogenannte Dipol- beziehungsweise Quadrupol-Pupillenausleuchtung.

Mit weiteren Blendeneinrichtungen unmittelbar vor oder hinter den Feldwaben sind einzelne Feldwaben ganz oder teilweise ausblendbar. Dadurch ist es möglich, daß nur die Bereiche der Feldwaben an der Ausleuchtung der Blendenebene teilhaben, die auf ihrer ganzen Breite beleuchtet sind. Dies führt zu einer gesteigerten Uniformität der Ausleuchtung der Bildebene des Beleuchtungssystems.

Um die x-Feldwaben und die y-Feldwaben bei ausgedehnten sekundären Lichtquellen möglichst randscharf in die Bildebene des Beleuchtungssystems abbilden zu können, ist es vorteilhaft, wenn der Wabenkondensor eine Platte mit einer zweidimensionalen Anordnung von torischen Linsen aufweist. Jede torische Linse bildet zusammen mit einer y-Feldwabe und einer x-Feldwabe einen optischen Kanal. Der optische Kanal umfaßt dabei nicht die gesamte y- und x-Feldwabe, sondern nur den Bereich der Feldwaben, der sich bei einer Projektion in Lichtrichtung als Schnittmenge der beiden gekreuzt angeordneten y- und x-Feldwaben mit der torischen Linse ergibt. Der optische Kanal weist in seiner Mitte eine zur optischen Achse des Wabenkondensors parallele gerade Achse auf, auf der y-Feldwabe, x-Feldwabe und torische Linse angeordnet sind und die torische Linse im Flächenscheitel schneidet. Die optischen Kanäle sind entsprechend der Breiten der Feldwaben rechteckig, bei gleicher Feldwabenbreite quadratisch begrenzt. Die beiden Hauptachsen der torischen Linsen sind so ausgerichtet, daß die eine Hauptachse parallel zu den Zylinderachsen der y-Feldwaben und die andere Hauptachse parallel zu den Zylinderachsen der x-Feldwaben verläuft.

Es ist vorteilhaft, die optischen Wirkungen der y-Feldwaben, x-Feldwaben und torischen Linsen derart auszulegen, daß die hinteren Brennpunkte der aus einer y-Feldwabe, einer x-Feldwabe und einer torischen Linse gebildeten optischen Kanäle in der Nähe der Blendenebene liegen. Dadurch wird ein auf den Wabenkondensor treffendes paralleles Strahlenbündel zunächst in eine Vielzahl von Strahlenbündeln zerlegt und diese in die Blendenebene oder in deren Nähe fokussiert, wodurch dort die sekundären Lichtquellen erzeugt werden.

Die Verwendung von Zylinderlinsen beziehungsweise von torischen Linsen legt die Betrachtung in zwei senkrecht zueinander stehenden Ebenen nahe. Eine Ebene, deren Flächennormale in Richtung der Zylinderachse der y-Feldwaben eines optischen Kanals zeigt und welche die Achse des betrachteten optischen Kanals beinhaltet, wird im folgenden als "Meridionalebene" bezeichnet. Optische Größen wie Brennpunkt und Brennweite für einen betrachteten optischen Kanal erhalten das Attribut "meridional", wenn sie durch Strahlen bestimmt werden, die ausschließlich in der Meridionalebene verlaufen. Eine Ebene, deren Flächennormale in Richtung der Zylinderachse der x-Feldwaben eines optischen Kanals zeigt und welche die Achse des betrachteten optischen Kanals beinhaltet, wird im folgenden als "Sagittalebene" bezeichnet. Optische Größen wie Brennpunkt und Brennweite für einen betrachteten optischen Kanal erhalten das Attribut "sagittal", wenn sie durch Strahlen bestimmt werden, die ausschließlich in der Sagittalebene verlaufen.

Die Mikrozylinderlinsen werden bei der Bestimmung der optischen Größen für die optischen Kanäle nur mit ihrer mittleren Dicke als Planplatten ohne ihre Zylinderwirkung berücksichtigt. Die Bestimmung der Brennweite oder des Brennpunktes eines optischen Kanals schließt deshalb die als Planplatte berücksichtigten y- und x-Mikrozylinderlinsen mit ein. Der Einfluß dieser äquivalenten Planplatten auf die Brennweiten und Brennpunkte ist jedoch gering.

Es ist vorteilhaft, die optischen Wirkungen der y-Feldwaben und des in y-Richtung weisenden Schnittes der torischen Linsen derart auszulegen, daß sich die meridionalen vorderen Brennpunkte am Ort der y-Feldwaben befinden. Da sich der hintere Brennpunkt der auf die Blendenebene folgenden Kondensoroptik in der Bildebene des Beleuchtungssystems befindet, ergibt sich im Meridionalschnitt eine optisch konjugierte Anordnung von y-Feldwaben und Bildebene. Die y-Feldwaben werden deshalb in die Bildebene abgebildet. Gleichzeitig ist es vorteilhaft, wenn die optischen Wirkungen der x-Feldwaben und des in x-Richtung weisenden Schnittes der torischen Linsen derart ausgelegt sind, daß sich die sagittalen vorderen Brennpunkte am Ort der x-Feldwaben befinden. Somit werden die x-Feldwaben ebenfalls in die Bildebene abgebildet. Das auszuleuchtende Feld in der Bildebene ist durch diese Maßnahmen randscharf begrenzt. Durch die Überlagerung der Vielzahl von Strahlenbündeln wird zudem eine sehr homogene Ausleuchtung des Feldes erreicht. Da die torischen Linsen den größten Teil der optischen Wirkung zur Abbildung der Feldwaben beitragen und in der Nähe der Blendenebene angeordnet sind, werden sie im folgenden als Pupillenwaben bezeichnet.

Anstelle der Platte mit einer zweidimensionalen Anordnung von torischen Linsen kann insbesondere für eine als Scanner ausgelegte Mikrolithographie-Projektionsbelichtungsanlage der Wabenkondensor eine weitere Platte mit Zylinderlinsen aufweisen, deren Zylinderachsen parallel zu den Zylinderachsen der x-Feldwaben ausgerichtet sind. Diese Zylinderlinsen werden im folgenden als x-Pupillenwaben bezeichnet. Die x-Pupillenwaben haben vorzugsweise eine plane und eine zylindrische Fläche. Die zylindrische Fläche weist senkrecht zur Zylinderachse einen konvexen Querschnitt und parallel zur Zylinderachse einen planen Querschnitt auf. Die zylindrische Fläche ist dabei vorzugsweise der Blendenebene zugewandt. Jede x-Pupillenwabe bildet zusammen mit einer y-Feldwabe und einer x-Feldwabe einen optischen Kanal. Der optische Kanal umfaßt dabei nicht die gesamte y-Feldwabe, x-Feldwabe und x-Pupillenwabe, sondern nur den Bereich der Feldwaben und der x-Pupillenwabe, der sich bei einer Projektion in Lichtrichtung als Schnittmenge der beiden gekreuzt angeordneten y- und x-Feldwaben und der x-Pupillenwabe ergibt. Der optische Kanal weist in seiner Mitte eine zur optischen Achse des Wabenkondensors parallel verlaufende gerade Achse auf, auf der y-Feldwabe, x-Feldwabe und x-Pupillenwabe angeordnet sind. Damit die sekundären Lichtquellen in der Blendenebene oder in deren Nähe zum Liegen kommen, ist es vorteilhaft, wenn sich die hinteren Brennpunkte der optischen Kanäle dort befinden.

Es ist weiterhin vorteilhaft, wenn die optische Wirkung der x-Feldwaben und der x-Pupillenwaben so ausgelegt sind, daß sich die sagittalen vorderen Brennpunkte am Ort der x-Feldwaben befinden. Die x-Pupillenwaben und die auf die Blendenebene folgende Kondensoroptik bilden dann im Sagittalschnitt die x-Feldwaben in die Bildebene nahezu randscharf ab.

Damit die Schwerstrahlen der Strahlenbüschel in der Bildebene des Beleuchtungssystems nahezu parallel zur optischen Achse verlaufen, ist es vorteilhaft, die optische Wirkung der y-Feldwaben derart auszulegen, daß der Abstand zwischen der Blendenebene und den hinteren meridionalen Brennpunkten nahezu gleich der halben meridionalen Brennweite ist.

Wabenkondensoren, die neben den y- und x-Feldwaben nur x-Pupillenwaben aufweisen, lassen sich vorteilhaft in als Scanner ausgelegten Mikrolithographie-Projektionsbelichtungsanlagen einsetzen. Bei diesen Systemen muß nur die kurze Feldseite des auszuleuchtenden Feldes, die in Scan-Richtung verläuft, randscharf begrenzt sein. In Scan-Richtung, also der y-Richtung ist ein sanfter Anstieg der Intensität bei gepulsten Lichtquellen, wie Laser-Lichtquellen sogar vorteilhaft, um Puls-Quantisierungseffekte zu reduzieren.

Für eine randscharfe Begrenzung des ausgeleuchteten Feldes auch in y-Richtung ist es vorteilhaft, wenn der Wabenkondensor neben der Platte mit den x-Pupillenwaben eine weitere Platte mit Zylinderlinsen aufweist, deren Zylinderachsen parallel zu den Zylinderachsen der y-Feldwaben ausgerichtet sind. Diese Zylinderlinsen werden im folgenden als y-Pupillenwaben bezeichnet. Die y-Pupillenwaben haben vorzugsweise eine plane und eine zylindrische Fläche. Die zylindrische Fläche weist senkrecht zur Zylinderachse eine konvexen Querschnitt und parallel zur Zylinderachse einen planen Querschnitt auf. Die zylindrische Fläche ist dabei vorzugsweise der Blendenebene zugewandt.

Jede y-Pupillenwabe bildet zusammen mit einer x-Pupillenwabe, einer x-Feldwabe und einer y-Feldwabe einen optischen Kanal. Der optische Kanal umfaßt dabei nicht die gesamte y-Pupillenwabe, x-Pupillenwabe, x-Feldwabe und y-Feldwabe, sondern nur den Bereich der Feldwaben und der Pupillenwaben, der sich bei einer Projektion in Lichtrichtung als Schnittmenge der ausgewählten Feld- und Pupillenwaben ergibt. Der optische Kanal weist in seiner Mitte eine parallel zur optischen Achse des Wabenkondensors verlaufende gerade Achse auf, auf der y-Feldwabe, x-Feldwabe, x-Pupillenwabe und y-Pupillenwabe angeordnet sind. Damit die sekundären Lichtquellen in der Blendenebene oder in deren Nähe zum Liegen kommen, ist es vorteilhaft, wenn sich die hinteren Brennpunkte der optischen Kanäle dort befinden.

Zur randscharfen Begrenzung des ausgeleuchteten Feldes in der Bildebene des Beleuchtungssystems ist es vorteilhaft, wenn sich die vorderen meridionalen Brennpunkte der optischen Kanäle am Ort der y-Feldwaben und die vorderen sagittalen Brennpunkte der optischen Kanäle am Ort der x-Feldwaben befinden.

Ähnlich wie bei dem Wabenkondensor mit den aus torischen Linsen gebildeten Pupillenwaben ist es vorteilhaft, wenn die y-Feldwaben, die x-Feldwaben, die x-Pupillenwaben und die y-Pupillenwaben die gleiche Breite aufweisen. Dann sind die optischen Kanäle quadratisch begrenzt und die sekundären Lichtquellen in der Retikelebene liegen auf einem quadratischen Gitter.

Damit die Blendenebene zugänglich ist, sind die Pupillenwaben in einem endlichen Abstand zur Blendenebene angeordnet. Dies führt zu unbeleuchteten Bereichen zwischen den sekundären Lichtquellen, selbst wenn mit Hilfe der x-Mikrozylinderlinsen und der y-Mikrozylinderlinsen die Pupillenwaben bis zum Rand jedes optischen Kanals ausgeleuchtet sind. Die unbeleuchteten Bereiche bilden unbeleuchtete Streifen parallel zu den Zylinderachsen der x- und y-Feldwaben. Die unbeleuchteten Streifen in x-Richtung sind im Abstand der Breite der y-Feldwaben, die unbeleuchteten Streifen in y-Richtung sind im Abstand der Breite der x-Feldwaben angeordnet. Um die Blendenebene möglichst vollständig auszuleuchten, sind die Breiten der unbeleuchteten Streifen kleiner als 20% des Abstandes von benachbarten unbeleuchteten Streifen.

Es ist weiterhin vorteilhaft, die Breite dieser unbeleuchteten Streifen gleich groß zu wählen, unabhängig davon, ob sie in Richtung der Zylinderachsen der y-Feldwaben oder der x-Feldwaben zeigen. Neben einer zur Blendenmitte punktsymmetrischen Ausleuchtung der Blendenebene erreicht man damit, daß zwei Sektoren, die durch Spiegelung an der x- und/oder y-Achse ineinander übergeführt werden können, mit der gleichen integralen Intensität beleuchtet werden. So weist jeder durch die x- und y-Achse begrenzte Quadrant oder jeder Quadrant, der durch zwei unter 45° zur x- und y-Achse liegenden Geraden begrenzt wird, die gleiche integrale Intensität auf. Die Blendenebene wird in diesem Fall spiegelsymmetrisch zur x- und y-Achse beleuchtet. Durch die derart ausgeleuchtete Blendenebene werden senkrecht aufeinander stehende Strukturen des nachfolgenden Retikels mit gleicher Qualität auf den Wafer abgebildet.

Um die Reflektionsverluste an Grenzflächen zu reduzieren, ist es vorteilhaft, die x-Pupillenwaben und die y-Pupillenwaben zu vereinigen oder als beidseitig strukturierte Platte aufzubauen.

Ein Beleuchtungssystem mit einem der zuvor beschriebenen Wabenkondensoren läßt sich besonders gut in einer Mikrolithographie-Projektionsbelichtungsanlage einsetzen. In der Bildebene oder in einer dazu konjugierten Ebene des Beleuchtungssystems wird dann das Retikel angeordnet, das die abzubildenden Strukturen aufweist. Um die Größe des ausgeleuchteten Bereiches auf dem Retikel zu variieren, ist es vorteilhaft, wenn in der Bildebene des Beleuchtungssystems eine Maskierungseinrichtung angebracht ist, die mit einem Objektiv auf das Retikel abgebildet wird. Auf das Retikel folgt ein Projektionsobjektiv, das die Strukturen des Retikels auf ein lichtempfindliches Objekt, beispielsweise einen Wafer, abbildet. Derartige Projektionsobjektive sind beispielsweise aus US 5,402,267 (DE 4203464 A) bekannt.

Mit einer derartig ausgestalteten Mikrolithographie-Projektionsbelichtungsanlage lassen sich mikrostrukturierte Bauteile mit Strukturen kleiner 500nm, bevorzugt kleiner 200nm herstellen.

Nachfolgend werden Einzelheiten der Erfindung anhand der in den Figuren dargestellten Ausführungsbeispiele näher erläutert. Im einzelnen zeigen:

Figur 1:  eine schematische Darstellung eines Beleuchtungssystems mit einem ersten Ausführungsbeispiel für ein Wabenkondensor-Feldlinse-Modul;

Figur 2:  eine schematische Darstellung eines ersten Ausführungsbeispiels für ein Wabenkondensor-Feldlinse-Modul;

Figur 3:  einen Linsenschnitt für eine asphärische Feldlinse;

Figur 4:  die Ausleuchtung der Blendenebene des Beleuchtungssystems mit einem Wabenkondensor-Feldlinse-Modul gemäß dem ersten Ausführungsbeispiel;

Figur 5:  eine schematische Darstellung eines zweiten Ausführungsbeispiels für ein Wabenkondensor-Feldlinse-Modul;

Figur 6:  eine schematische Darstellung eines dritten Ausführungsbeispiels für ein Wabenkondensor-Feldlinse-Modul;

Figur 7:  eine schematische Darstellung eines vierten Ausführungsbeispiels für ein Wabenkondensor-Feldlinse-Modul;

Figur 8:  eine schematische Darstellung eines fünften Ausführungsbeispiels für ein Wabenkondensor-Feldlinse-Modul; und

Figur 9:  eine schematische Darstellung eines sechsten Ausführungsbeispiels für ein Wabenkondensor-Feldlinse-Modul;

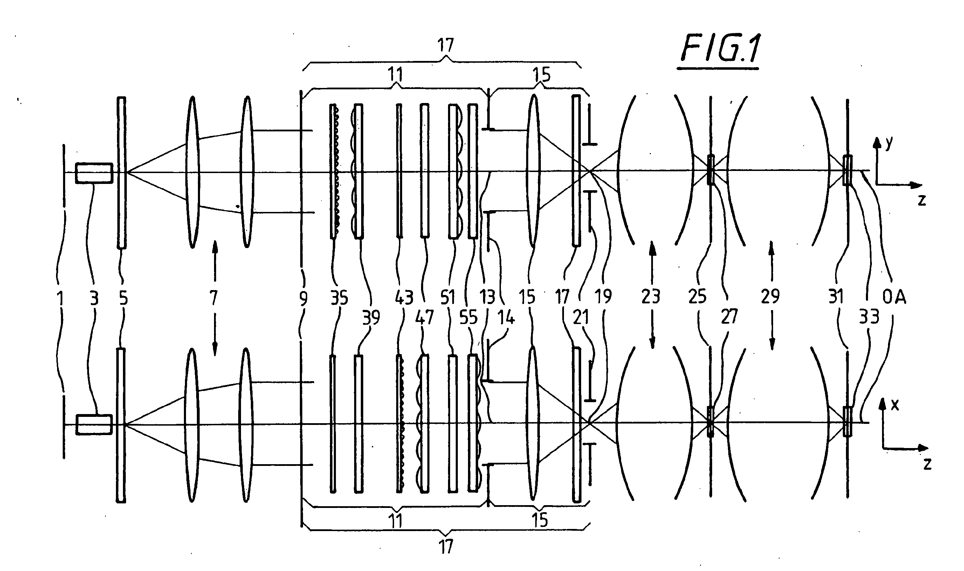

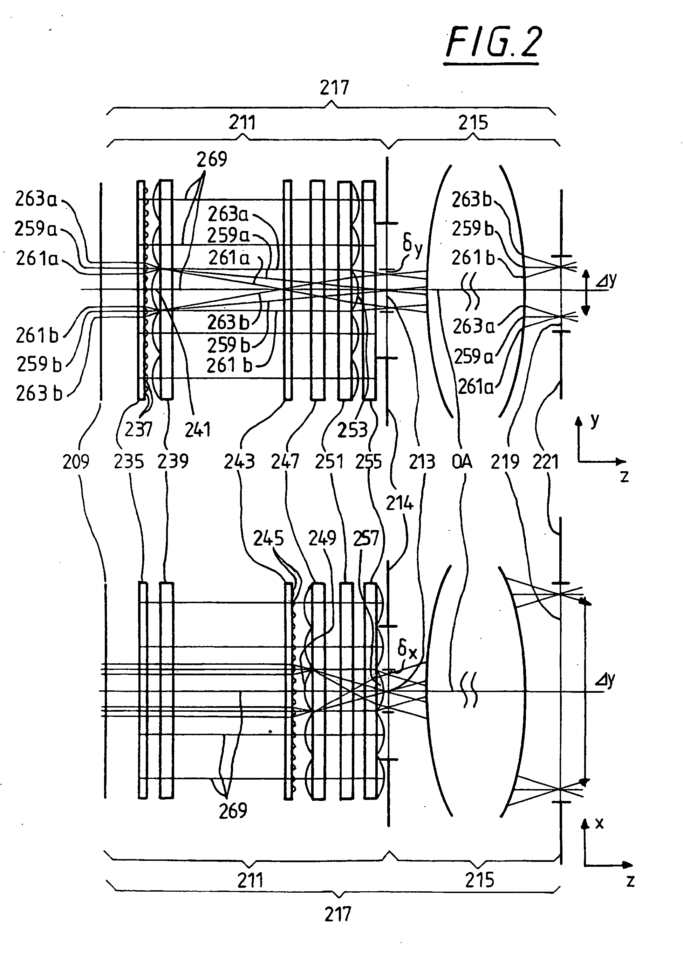

Fig. 1 zeigt in schematischer Darstellung eine Mikrolithographie-Projektionsbelichtungsanlage von der Lichtquelle 1 bis zum Wafer 33. Die obere Darstellung zeigt eine Seitenansicht (y-z-Schnitt), die untere Darstellung eine Draufsicht (x-y-Schnitt). Als Lichtquelle 1 kann unter anderem ein DUV- oder VUV-Laser eingesetzt werden, beispielsweise ein ArF-Laser für 193nm, ein $F_2$-Laser für 157nm, ein $Ar_2$-Laser Für 126nm und ein NeF-Laser für 109nm. Durch eine Strahlformungsoptik 3 wird ein paralleles Lichtbündel erzeugt, das auf ein Divergenz erhöhendes optisches Element 5 trifft. Als Divergenz erhöhendes optisches Element 5 kann beispielsweise eine Rasterplatte aus diffraktiven oder refraktiven Rasterelementen eingesetzt werden. Jedes Rasterelement erzeugt ein Strahlenbüschel, dessen Winkelverteilung durch Ausdehnung und Brennweite des Rasterelementes bestimmt ist. Die Rasterplatte befindet sich in der Objektebene eines nachfolgenden Objektives 7 oder in deren Nähe. In der Blendenebene 9 des Objektives 7 werden die von den Rasterelementen erzeugten Strahlenbüschel überlagert und leuchten die Blendenebene 9 des Objektivs 7 aus. Das Objektiv 7 kann als Zoom-Objektiv auslegt sein, um die Ausdehnung der Ausleuchtung der Blendenebene 9 zu variieren. Durch den Einsatz von zwei entlang der optischen Achse verschiebbaren Axikonlinsen unmittelbar vor der Blendenebene 9 kann auch eine annulare Ausleuchtung mit variabler Ringbreite erzielt werden. Ein derartiges Zoom-Axikon-Objektiv ist aus DE 44 41 947 A bekannt. Durch Tausch des Apertur erzeugenden Elementes 5 kann ebenfalls die Ausleuchtung variiert werden. Spezielle Apertur erzeugende Elemente 5 lassen auch die sogenannte Quadrupol-Beleuchtung mit vier separierten Bereichen zu. Die Blendenebene 9 des Objektivs 7 ist die Eintrittsebene eines Wabenkondensors 11. In der Nähe der Austrittsebene des Wabenkondensors 11 befindet sich eine Blendenebene 13 des gesamten Beleuchtungssystems. In der Blendenebene 13 kann die Ausleuchtung der Blende über Masken 14 oder Transmissionsfilter gesteuert werden. Auf den Wabenkondensor 11 folgt eine Kondensoroptik 15, die sogenannte Feldlinse 15. Das optische System aus Wabenkondensor 11 und Feldlinse 15 wird im folgenden als Wabenkondensor-Feldlinse-Modul 17 bezeichnet. Das dargestellte Wabenkondensor-Feldlinse-Modul 17 ist in Fig. 2 vergrößert dargestellt und wird bei der Beschreibung von Fig. 2 näher erläutert. Das Wabenkondensor-Feldlinse-Modul 17 leuchtet eine zur Retikelebene konjugierte Ebene 19 aus, in der sich eine Maskierungsvorrichtung 21 zur Begrenzung der Feldausleuchtung befindet. Diese Maskierungsvorrichtung 21 wird auch als Rema (reticle masking) bezeichnet. Das Rema 21 wird mit Hilfe eines sogenannten Rema-Objektives 23 in die Retikelebene 25 abgebildet. Remaobjektive 23 sind aus US 5,982,558 (DE 195 48 805 A) bekannt. Sie haben dabei einen Abbildungsmaßstab zwischen 1:1 und 1:5. Vor der Ebene mit dem Rema ist eine Streuscheibe 17 angebracht, welche die Pupillenausleuchtung homogenisiert und Korrelationseffekte aufgrund der Rasterung der Platten 35, 39, 43, 47, 51, 55 zerstört. Die Streuscheibe kann aber auch innerhalb des Wabenkondensors 11 nach den Platten 139 und 151 mit den Feldwaben, in der Nähe einer zur Retikelebene 25 konjugierten Ebene oder vor der Retikelebene 25 angebracht werden. Die Streuscheibe hat dabei eine geringe Streuwirkung, die so ausgelegt ist, daß die von den Mikrozylinderlinsen erzeugten Intensitätspeaks in der Pupillenausleuchtung bis auf den Abstand der Intensitätspeaks verbreitert werden. In der Retikelebene 25 befindet sich das Retikel 27, das mit einem Projektionsobjektiv 29 in die Waferebene 33 abgebildet wird. Sowohl Retikel 27 wie auch Wafer 33 befinden sich auf einer nicht dargestellten Haltevorrichtung. Diese Haltevorrichtung läßt den Austausch von Retikel 27 und Wafer 33 zu. In sogenannten Scanner-Systemen werden Retikel 27 und Wafer 33 im Verhältnis des Abbildungsmaßstabes des Projektionsobjektives 29 in Scan-Richtung bewegt. Die Scan-Richtung ist in der vorliegenden Ausführungsform die y-Richtung.

Das auszuleuchtende Feld in der Retikelebene 25 ist rechteckig begrenzt. Das Rechteck ist dabei so ausgerichtet, daß die längere Feldseite in x-Richtung weist. Das x-y-Aspektverhältnis des Rechteckes weist eine Wert zwischen 2:1 und 12:1 auf.

Ausführungsbeispiel 1:

Fig. 2 zeigt ein erstes Ausführungsbeispiel für ein Wabenkondensor-Feldlinse-Modul 217 in schematischer Darstellung. Die obere Darstellung zeigt eine Seitenansicht (y-z-Schnitt), die untere Darstellung eine Draufsicht (x-y-Schnitt). Die den Elementen von Figur 1 entsprechenden Elemente in Figur 2 haben die gleichen Bezugszeichen wie in Figur 1 vermehrt um die Zahl 200.

Nach der Eintrittsfläche 209 des Wabenkondensors 211 folgt in Lichtrichtung eine Platte 235 mit y-Mikrozylinderlinsen 237. Die y-Mikrozylinderlinsen 237 haben in y-Richtung eine Breite $b_3$ und in x-Richtung eine Länge $l_3$, die dem maximalen Durchmesser des Wabenkondensors 211 entspricht. Die dargestellten y-Mikrozylinderlinsen 237 wirken im Meridionalschnitt sammelnd, können aber auch zerstreuend ausgelegt sein. Ihre optische Wirkung im Meridionalschnitt ist durch die Brennweite $f_3$ gegeben. Im Sagittalschnitt weisen sie keine optische Wirkung auf. In Ausführungsbeispiel 1 sind sie als stabförmige plan-konvex-Zylinderlinsen ausgeführt. Sie sind im x-z-Schnitt als Planplatten dargestellt, da sie im Sagittalschnitt keine Wirkung haben.

Nach der Platte 235 mit y-Mikrozylinderlinsen 237 folgt eine Platte 239 mit y-Feldwaben 241, die in y-Richtung eine Breite $b_1$ und in x-Richtung eine Länge $l_1$, die dem maximalen Durchmesser des Wabenkondensors 211 entspricht, haben. Die y-Feldwaben 241 haben im Meridionalschnitt eine positive Brechkraft und eine Brennweite von $f_1$. In Ausführungsbeispiel 1 sind sie als plan-konvex-Zylinderlinsen ausgeführt, wobei die konvexen Flächen Richtung Lichtquelle zeigen. Im x-z-Schnitt sind sie als Planplatte dargestellt.

Nach der Platte 239 mit den y-Feldwaben 241 folgt eine Platte 243 mit x-Mikrozylinderlinsen 245. Die x-Mikrozylinderlinsen 245 haben in x-Richtung eine Breite $b_4$ und in y-Richtung eine Länge $l_4$, die dem maximalen Durchmesser des Wabenkondensors 211 entspricht. Die dargestellten x-Mikrozylinderlinsen 245 wirken im Sagittalschnitt sammelnd, können aber auch zerstreuend ausgelegt sein. Ihre optische Wirkung im Sagittalschnitt ist durch die Brennweite $f_4$ gegeben.

Nach der Platte 243 mit den x-Mikrozylinderlinsen 245 folgt eine Platte 247 mit x-Feldwaben 249. Die x-Feldwaben 249 haben in x-Richtung eine Breite $b_2$ und in y-Richtung eine Länge $l_2$, die dem maximalen Durchmesser des Wabenkondensors 211 entspricht. Die x-Feldwaben 249 haben im Sagittalschnitt eine positive Brechkraft und eine Brennweite von $f_2$. In Ausführungsbeispiel 1 sind sie als stabförmige plan-konvex-Zylinderlinsen ausgeführt, wobei die konvexen Flächen Richtung Lichtquelle zeigen. Im y-z-Schnitt sind sie als Planplatte dargestellt.

Nach der Platte 247 mit den x-Feldwaben 249 folgt eine Platte 251 mit y-Pupillenwaben 253, die im Meridionalschnitt eine positive Brechkraft haben. In Ausführungsbeispiel 1 sind sie als plan-konvex-Zylinderlinsen ausgeführt, wobei die konvexen Flächen von der Lichtquelle abgewandt sind. Im x-z-Schnitt sind sie als Planplatte dargestellt. Die Breite der y-Pupillenwaben 253 ist dabei gleich der Breite der y-Feldwaben 241.

Nach der Platte 251 mit den y-Pupillenwaben 253 folgt eine Platte 255 mit x-Pupillenwaben 257, die im Sagittalschnitt eine positive Brechkraft haben. In Ausführungsbeispiel 1 sind sie als plan-konvex-Linsen ausgeführt, wobei die konvexen Flächen von der Lichtquelle abgewandt sind. Im y-z-Schnitt sind sie als Planplatte dargestellt. Die Breite der x-Pupillenwaben 257 ist dabei gleich der Breite der x-Feldwaben 249.

Die Platte 255 mit den x-Pupillenwaben 257 und die Platte 251 mit den y-Pupillenwaben 253 können in ihrer Reihenfolge auch vertauscht angeordnet sein.

Nach den Platten mit den Pupillenwaben folgt eine für das gesamte Beleuchtungssystem als Blendenebene wirkende Ebene 213. Zwischen Blendenebene 213 und Feldebene 219 ist eine Feldlinse 215 angeordnet.

Die Funktionsweise des aus Zylinderlinsen-Arrays und der Feldlinse 215 aufgebauten Wabenkondensors-Feldlinse-Moduls 217 wird im folgenden näher erläutert.

Die Eintrittsfläche 209 wird mit nahezu parallelem Licht beleuchtet. Bei typischen Laserlichtquellen weist das einfallende parallele Strahlenbüschel im allgemeinen eine Divergenz vonim Bereich $\pm$ 25 mrad auf. Die Intensität der Ausleuchtung und die lokale Winkelverteilung sind dabei innerhalb des ausgeleuchteten Bereiches für jeden Feldpunkt nahezu gleich.

In Fig. 2 ist im y-z-Schnitt die Abbildung der y-Feldwaben 241 auf das auszuleuchtende Feld in der Feldebene 219 dargestellt. Die im folgenden betrachteten Lichtstrahlen verlaufen in der Meridionalebene. Parallel auf die zentrale y-Feldwabe treffende Strahlen werden in die Blendenebene 213 fokussiert, so daß jede y-Feldwabe 241 in der Blendenebene 213 eine sekundäre Lichtquelle erzeugt. Der hintere Brennpunkt für den y-z-Schnitt des aus y-Feldwabe 241, x-Feldwabe 249, y-Pupillenwabe 253 und x-Pupillenwabe 257 gebildeten optischen Kanals befindet sich folglich in der Blendenebene 213, wobei die x-Feldwabe 249 und die x-Pupillenwabe 257 in diesem Schnitt nur als Planflächen wirken.

Die in die Blendenebene 213 fokussierten Strahlen divergieren nach der Blendenebene 213 und verlassen in Ausführungsbeispiel 1 die Feldlinse 215 als parallele Strahlen, da die Blendenebene 213 in der vorderen Brennebene der Feldlinse 215 angeordnet ist. Die Feldebene 219 wird somit telezentrisch beleuchtet. Falls die Beleuchtung der Feldebene 219 nicht telezentrisch sein soll, also die Austrittspupille des Beleuchtungssystems im Endlichen liegt, müssen über das Design der Feldlinse 215 die Schwerstrahlwinkel eingestellt werden.

In der Blendenebene 213 parallel verlaufende Strahlen werden in die Feldebene 219 fokussiert, da sich die hintere Brennebene der Feldlinse 215 in der Feldebene 219 befindet. Die Breite des ausgeleuchteten Feldes in der Feldebene 219 beträgt $\Delta y$ und ist durch den maximalen Divergenzwinkel der Strahlen in der Blendenebene 213 bestimmt.

Ohne die y-Mikrozylinderlinsen 237 würden die y-Feldwaben 241 ausschließlich mit parallelem Licht geringer Divergenz beleuchtet. In diesem Fall wäre die Blendenebene 213 entsprechend der Anordnung der y- und x-Feldwaben nur mit diskreten Intensitätspeaks beleuchtet. In der nach der Feldlinse 215 folgenden Feldebene 219 würden die Strahlwinkel aus diskreten Richtungen kommen. Die y-Mikrozylinderlinsen 237 in Ausführungsbeispiel 1 sind nun so ausgelegt, daß die y-Feldwaben 241 nicht mit einem zur optischen Achse parallelen Strahlenbüschel, sondern in der y-z-Ebene aus verschiedenen Richtungen beleuchtet werden. Die maximalen Divergenzwinkel sind in Ausführungsbeispiel 1 so bestimmt, daß die y-Pupillenwaben 253 vollständig ausgeleuchtet werden. Dies ist dann der Fall, wenn ein Strahl maximaler Divergenz, der an den Rand einer y-Feldwabe 241 trifft, zwischen y-Feldwabe 241 und y-Pupillenwabe 253 parallel verläuft und auf den Rand der y-Pupillenwabe 253 trifft. Neben den parallel zur optischen Achse auf die y-Feldwabe 241 treffenden Strahlen 259a-b sind zwei weitere Strahlpaare 261a-b und 263a-b eingezeichnet, die mit maximaler Divergenz auf den Rand der y-Feldwabe 241 treffen, wobei Strahl 263a und 261b parallel zur optischen Achse zwischen y-Feldwabe 241 und y-Pupillenwabe 253 verlaufen. Die Brennweite der y-Pupillenwabe 253 ist so ausgelegt, daß die von einem Objektpunkt auf der y-Feldwabe ausgehenden Strahlen 263a, 259a und 261a, beziehungsweise 263b, 259b und 261b in der Blendenebene parallel zueinander verlaufen. Der vordere meridionale Brennpunkt des aus y-Feldwabe 241, x-Feldwabe 249, y-Pupillenwabe 253 und x-Pupillenwabe 257 gebildeten optischen Kanals im y-z-Schnitt befindet sich folglich am Ort der y-Feldwaben 241. Die in der Blendenebene 213 parallel zueinander verlaufenden Strahlen werden durch die Feldlinse in die Feldebene fokussiert. Der von den Strahlen 263b, 259b und 261b gebildete Fokus liegt am oberen Feldrand, der von den Strahlen 263a, 259a und 261a gebildete Fokus am unteren Feldrand. Die y-Pupillenwaben 253 zusammen mit der Feldlinse 215 erzeugen im y-z-Schnitt somit ein Bild der y-Feldwaben 253 in der Feldebene 219.

Die Ausleuchtung jedes optischen Kanals in der Blendenebene 213 in y-Richtung und damit auch der Blendenebene 213 ist durch die Divergenz der auf die y-Feldwaben 241 treffenden Strahlen bestimmt. Die maximale Strahldivergenz wiederum ergibt sich aus der Brennweite $f_3$ und der Breite $b_3$ der y-Mikrozylinderlinsen 237. Die Ausleuchtung des optischen Kanals hängt mit den Parametern der y-Mikrozylinderlinsen 237 und der y-Feldwaben 253 näherungsweise folgendermaßen zusammen:

$$\eta_y \approx \frac{b_3}{b_1} \cdot \frac{f_1}{f_3} \qquad\qquad (1)$$

$f_3$: Brennweite der y-Mikrozylinderlinsen 237
$b_3$: Breite der y-Mikrozylinderlinsen 237
$f_1$ : Brennweite der y-Feldwaben 241
$b_1$: Breite der y-Feldwaben 241
$\eta_y$: Füllgrad:

$\eta_y$ = 1.0 nahezu vollständige Ausleuchtung des optischen Kanals in y-Richtung (siehe Ausführungsbeispiel 1)
$\eta_y$ = 0.5 halbe Ausleuchtung des optischen Kanals

Auf Grund des endlichen Abstandes der y-Pupillenwaben 253 von der Blendenebene 213 kann die Blendenebene 213 nicht vollständig ausgeleuchtet werden. Lichtstrahlen die zwischen y-Feldwabe 241 und y-Pupillenwabe 253 parallel verlaufen, werden an der y-Pupillenwabe 253 in Richtung der Achse 269 jedes optischen Kanals fokussiert. Die beleuchtete Fläche für jeden optischen Kanal in der Blendenebene 213 hat deshalb nicht die Breite $b_1$, sondern eine um den Wert $\delta_y$ verringerte Breite. In der Blendenebene 213 bilden sich deshalb unbeleuchtete Streifen in x-Richtung der Breite $\delta_y$ in einem Abstand von $b_1$.

Die beleuchtete Fläche für jeden optischen Kanal in der Blendenebene 213 ist nicht homogen ausgeleuchtet, sondern weist auf Grund der Rasterung der y-Mikrozylinderlinsen 237 Intensitätsschwankungen auf. Je geringer die Breite der y-Mikrozylinderlinsen 237 im Vergleich zur Breite der y-Feldwaben 241 ist, desto homogener wird die beleuchtete Fläche für jeden Wabenkanal ausgeleuchtet.

In Fig. 2 unten ist im x-z-Schnitt die Abbildung der x-Feldwaben 249 auf das auszuleuchtende Feld in der Feldebene 219 dargestellt. Die Abbildung erfolgt analog zu den Ausführungen zur Abbildung der y-Feldwaben 241. Der hintere sagittale Brennpunkt des aus y-Feldwabe 241, x-Feldwabe 249, y-Pupillenwabe 253 und x-Pupillenwabe 257 gebildeten optischen Kanals befindet sich wiederum in der Blendenebene 213, wobei die y-Feldwabe 241 und die y-Pupillenwabe 253 in diesem Schnitt nur als Planflächen wirken.

Die x-Mikrozylinderlinsen 245 werden eingesetzt, um die Ausleuchtung der x-Pupillenwaben 257 zu erhöhen, indem die x-Feldwaben 249 nicht mit einem zur optischen Achse parallelen Strahlenbüschel, sondern in der x-z-Ebene aus verschiedenen Richtungen beleuchtet werden. Die maximalen Divergenzwinkel sind in Ausführungsbeispiel 1 so bestimmt, daß die x-Pupillenwaben 257 vollständig ausgeleuchtet werden. Dies ist dann der Fall, wenn ein Strahl maximaler Divergenz, der an den Rand einer x-Feldwabe trifft, zwischen x-Feldwabe und x-Pupillenwabe parallel verläuft und auf den Rand der x-Pupillenwabe trifft. Der vordere sagittale Brennpunkt des aus y-Feldwabe 241, x-Feldwabe 249, y-Pupillenwabe 253 und x-Pupillenwabe 257 gebildeten Kanals im x-z-Schnitt befindet sich am Ort der x-Feldwaben 249. Die in der Blendenebene 213 parallel verlaufenden Strahlen werden durch die Feldlinse 215 in die Feldebene 219 fokussiert. Die x-Pupillenwaben 257 zusammen mit der Feldlinse 215 erzeugen im x-z-Schnitt somit ein Bild der x-Feldwaben 249 in der Feldebene 215.

Die Ausleuchtung jedes optischen Kanals in der Blendenebene 213 in x-Richtung hängt mit den Parametern der x-Mikrozylinderlinsen 245 und der x-Feldwaben 249 näherungsweise folgendermaßen zusammen:

$$\eta_x \approx \cdot \frac{b_4}{b_2} \cdot \frac{f_2}{f_4} \qquad\qquad (2)$$

$f_4$: Brennweite der x-Mikrozylinderlinsen 245
$b_4$: Breite der x-Mikrozylinderlinsen 245
$f_2$: Brennweite der x-Feldwaben 249
$b_2$: Breite der x-Feldwaben 249
$\eta_x$: Füllgrad:

$\eta_x$ = 1.0 nahezu vollständige Ausleuchtung des optischen Kanals in der Blendenebene in x-Richtung (siehe Ausführungsbeispiel 1)
$\eta_x$ = 0.5 halbe Ausleuchtung des optischen Kanals

Auf Grund des endlichen Abstandes der x-Pupillenwaben 257 von der Blendenebene 213 kann die Blendenebene 213 nicht vollständig ausgeleuchtet werden. Lichtstrahlen, die zwischen x-Feldwabe 249 und x-Pupillenwabe 257 parallel verlaufen, werden an der x-Pupillenwabe 249 in Richtung der Achse jedes optischen Kanals 269 fokussiert. Die beleuchtete Fläche für jeden optischen Kanal in der Blendenebene 213 hat deshalb nicht die Breite b2, sondern eine um den Wert $\delta_x$ verringerte Breite. In der Blendenebene 213 bilden sich deshalb unbeleuchtete Streifen in y-Richtung der Breite $\delta_x$ in einem Abstand von $b_2$.

Die unbeleuchteten Streifen in x- und y-Richtung ergeben damit ein Gitter von unbeleuchteten Streifen. Wenn die Breite $b_1$ der y-Waben und die Breite $b_2$ der x-Waben gleich groß sind, so ist das Gitter quadratisch. Durch entsprechende Wahl der Radien und Dicken der Feld- und Pupillenwaben und den Abständen zwischen den einzelnen Komponenten kann erreicht werden, daß die unbeleuchteten Streifen in x- und y-Richtung die gleiche Breite $\delta_x = \delta_y$ aufweisen. Dadurch erreicht man eine punktsymmetrische Ausleuchtung der Blendenebene.

Im folgenden werden für das erste Ausführungsbeispiel konkrete Fertigungsdaten für das Wabenkondensor-Feldlinse-Modul 217 angegeben.

Tabelle 1

| Element | Flächennummer | $R_x$ [mm] | $R_y$ [mm] | d [mm] | Glas | B [mm] | f [mm] |
|---|---|---|---|---|---|---|---|
| y-Mikrozylinderlinse | 1 | ∞ | ∞ | 0,503 | CaF$_2$ | 0,30 | 6,50 |
| | 2 | ∞ | -3,627 | 19,922 | | 0,30 | |

(fortgesetzt)

| Element | Flächennummer | $R_x$ [mm] | $R_y$ [mm] | d [mm] | Glas | B [mm] | f [mm] |
|---|---|---|---|---|---|---|---|
| y-Feldwabe | 3 | ∞ | 26,787 | 2,075 | $CaF_2$ | 4,00 | 48,00 |
| | 4 | ∞ | ∞ | 20,750 | | 4,00 | |
| x-Mikrozylinderlinse | 5 | ∞ | ∞ | 0,517 | $CaF_2$ | 0,30 0,30 | 1,20 |
| | 6 | -0,669 | ∞ | 9,756 | | | |
| x-Feldwabe | 7 | 8,915 | ∞ | 2,977 | $CaF_2$ | 4,00 | 15,98 |
| | 8 | ∞ | ∞ | 7,850 | | 4,00 | |
| y-Pupillenwabe | 9 | ∞ | ∞ | 2,082 | $CaF_2$ | 4,00 | 43,74 |
| | 10 | ∞ | -24,407 | 0,918 | | 4,00 | |
| x-Pupillenwabe | 11 | ∞ | ∞ | 3,001 | $CaF_2$ | 4,00 | 14,51 |
| | 12 | -8,099 | ∞ | 1,649 | | 4,00 | |
| Blendenebene | 13 | ∞ | ∞ | | | | |

In Tabelle 1 sind die optischen Daten für den Wabenkondensor gemäß dem ersten Ausführungsbeispiel für eine Arbeitswellenlänge von $\lambda$ = 157.6 nm angegeben. Die Flächennummern geben die Reihenfolge der Flächen in Lichtrichtung wieder. Fläche 1 entspricht der planen Vorderfläche der Platte 235 mit den y-Mikrozylinderlinsen 237. Fläche 13 entspricht der Blendenebene 213. Die Breiten b sind dabei die Breiten der Zylinderlinsen senkrecht zu den jeweiligen Zylinderachsen. Die Brennweiten f beziehen sich auf die einzelnen Komponenten. Die Länge der Mikrozylinderlinsen, der Feldwaben und der Pupillenwaben beträgt 120 mm. Dabei sind auf einer Platte 400 Mikrozylinderlinsen, beziehungsweise 30 Feldwaben oder 30 Pupillenwaben angeordnet. Der Durchmesser des auf das Wabenkondensor-Feldlinse-Moduls treffenden parallelen Strahlbüschels beträgt 100 mm. Die Divergenz der Strahlen innerhalb des Strahlbüschels an der Eintrittsfläche des Wabenkondensors beträgt maximal $\pm$ 25 mrad.

Für den Füllgrad $\eta_y$ jedes optischen Kanals in y-Richtung erhält man

$$\eta_y \approx \frac{b_3}{b_1} \cdot \frac{f_1}{f_3} = \frac{0.3}{4.0} \cdot \frac{48}{6.5} = 0.55$$

Für den Füllgrad $\eta_x$ jedes optischen Kanals in x-Richtung erhält man

$$\eta_x \approx \frac{b_4}{b_2} \cdot \frac{f_2}{f_4} = \frac{0.3}{4.0} \cdot \frac{15.98}{1.2} = 0.99$$

Für die Breite $\delta_x$ der unbeleuchteten Streifen in y-Richtung erhält man $\delta_x \approx 0.4mm$
Für die Breite $\delta_y$ der unbeleuchteten Streifen in x-Richtung erhält man $\delta_y \approx 0.4mm$
Nach der Blendenebene 213 folgt die Feldlinse 215.

| Bezugszeichen in Fig. 3 | R [mm] | Asphäre | D[mm] | Glas |
|---|---|---|---|---|
| 301 | ∞ | | 3,758 | |
| 302 | 666,750 | A | 34,984 | $CaF_2$ |
| 303 | -349,228 | | 0,150 | |
| 304 | 1146,535 | | 34,985 | $CaF_2$ |

(fortgesetzt)

| Bezugzeichen in Fig. 3 | R [mm] | Asphäre | D[mm] | Glas |
|---|---|---|---|---|
| 305 | 562,165 | | 8,088 | |
| 306 | -1522,323 | | 30,125 | $CaF_2$ |
| 307 | -130,620 | | 0,207 | |
| 308 | 155,847 | | 31,092 | $CaF_2$ |
| 309 | -348,755 | | 21,245 | |
| 310 | 278,542 | | 16,679 | $CaF_2$ |
| 311 | -508,154 | | 34,220 | |
| 312 | $\infty$ | | | |

Asphäre auf Fläche 302:

Ex = 0,00559517
C1 = -2,62E-07
C2 = -3,16E-11

Asphärenformel :

$$z = \frac{\frac{1}{R}h^2}{1 + \sqrt{1 - (1 - EX)\left(\frac{1}{R}\right)^2 h^2}} + \sum_{k=1} c_k h^{2k+2}$$

z: Pfeilhöhe; h: Höhe; R: Radius; EX: Exzentrizität; $C_k$: Asphärenkonstanten

Tabelle 2

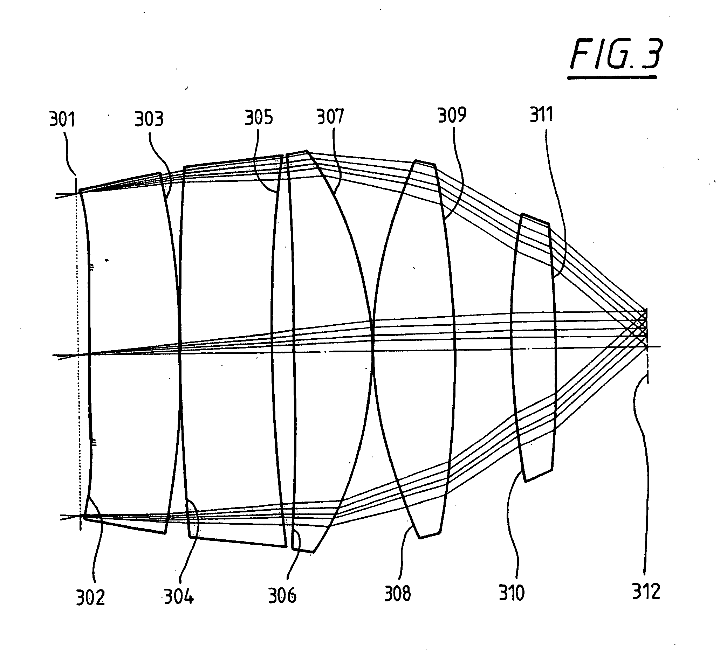

In Tabelle 2 sind die optischen Daten für die auf den Wabenkondensor 211 folgende Feldlinse 215 für eine Arbeitswellenlänge von $\lambda$ = 157.6 nm angegeben, wie sie auch in den anderen Ausführungsbeispielen zum Einsatz kommen kann. Die Flächennummern geben die Reihenfolge der Flächen in Lichtrichtung wieder. Fläche 301 entspricht der Blendenebene 213. Fläche 312 entspricht der Feldebene 219. Der Linsenschnitt der Feldlinse 215 ist in Fig. 3 dargestellt.
Der maxiamle Durchmesser des ausgeleuchteten Feldes in der Blendenebene beträgt 100mm.
Das auszuleuchtende Rechteckfeld in der Bildebene hat die Abmessungen $\Delta x$ = 26.0 mm und $\Delta y$ = 8.0 mm, das Seitenaspektverhältnis beträgt also 3.25:1.
Die Apertur in der Feldebene beträgt NA = 0.66.

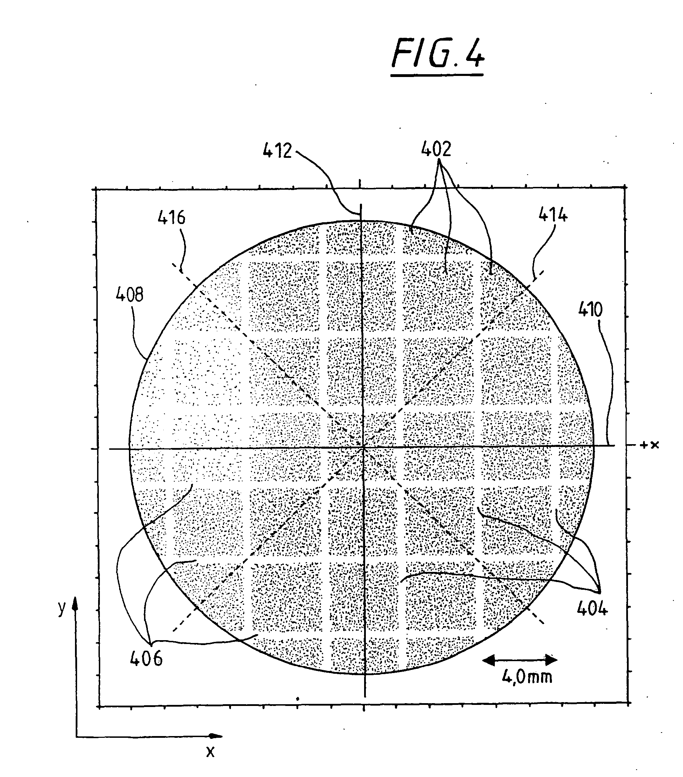

Fig. 4 zeigt die Ausleuchtung der Blendenebene 213 für einen Wabenkondensor 211 gemäß Tabelle 1, bei dem y-Feldwaben 241 und x-Feldwaben 249 mit einer gleichen Breite von 4.0 mm beleuchtet werden. Die Ausdehnung der Ausleuchtung der Feldwaben ist mit Hilfe des Zoom-Axikon-Objektives 7 eingestellt. Aufgrund der gleichen Breite der x- und y-Feldwaben ergibt sich ein quadratisches Gitter mit sekundären Lichtquellen 402. Die sekundären Lichtquellen 402 sind entsprechend der Auslegung der Mikrozylinderlinsen ebenfalls quadratisch. Durch den Einsatz einer Streuscheibe, die in Lichtrichtung nach den Platten mit Feldwaben angeordnet ist, sind die sekundären Lichtquellen 402 nahezu homogen ausgeleuchtet. Die diskrete Ausleuchtung der Blendenebene 213 aufgrund der Mikrozylinderlinsen ist nicht mehr zu sehen. Die Breite $\delta_x$ der unbeleuchteten Streifen 404 in y-Richtung und die Breite $\delta_y$ der unbeleuchteten Streifen 406 in x-Richtung zwischen den sekundären Lichtquellen 402 ist gleich groß und beträgt jeweils 0.4 mm. Das Verhältnis der Streifenbreite zum Abstand der unbeleuchteten Streifen beträgt also 10%. Die kreisrunde Begrenzung 408 der Ausleuchtung erfolgt durch die in der Blendenebene 213 angeordnete kreisrunde Blende 214. Die senkrecht aufeinander stehenden durchgezogen dargestellten Geraden 410 und 412 begrenzen vier Quadranten, die jeweils die gleiche integrale Intensität aufweisen. Auch die von den gestrichelt eingezeichneten Geraden 414 und 416 begrenzten Quadranten haben jeweils die gleiche integrale Intensität. Bei dieser Art von Ausleuchtung ist für zwei Sektoren in der Blendenebene, die sich durch eine Spiegelung an der x- und/oder an der y-Achse ineinander überführen lassen, die integrale Intensität gleich groß.

Ausführungsbeispiel 2:

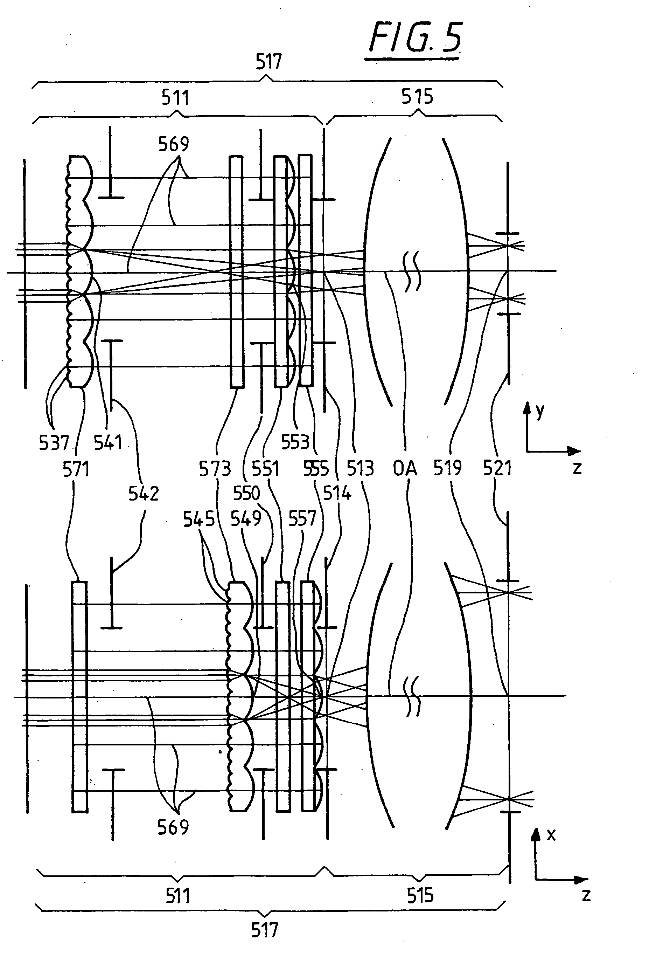

Fig. 5 zeigt ein zweites Ausführungsbeispiel für ein Wabenkondensor-Feldlinse-Modul 517 in schematischer Darstellung. Die obere Darstellung zeigt eine Seitenansicht (y-z-Schnitt), die untere Darstellung eine Draufsicht (x-y-Schnitt). Die den Elementen von Figur 2 entsprechenden Elemente in Figur 5 haben die gleichen Bezugszeichen wie in Figur 2 vermehrt um die Zahl 300. Für eine Beschreibung dieser Elemente wird auf die Beschreibung zu Figur 2 verwiesen.

Im zweiten Ausführungsbeispiel sind die Mikrozylinderlinsen und die Feldwaben auf einer Platte integriert. Dadurch lassen sich insgesamt vier Grenzflächen einsparen und die damit verbundenen Transmissionsverluste reduzieren. Die Platten 235 und 243 mit den Mikrozylinderlinsen wie auch die Platten 239 und 247 mit den Feldwaben in Figur 2 weisen jeweils eine plane Fläche auf. Durch Aneinanderfügen dieser planen Flächen fallen die Grenzflächen weg. Neben dem Verbinden der beiden Platten über eine Kittfläche oder durch Ansprengen ist auch die Strukturierung der Vorderfläche mit den Mikrozylinderlinsen und der Rückfläche mit den Feldwaben realisierbar. Die dadurch entstehenden Mikrozylinderlinsen-Feldwaben-Platten 571 und 573 sind so anzuordnen, daß die Mikrozylinderlinsen 537 und 545 in Lichtrichtung vor den entsprechenden Feldwaben 571 und 549 angeordnet sind. Im zweiten Ausführungsbeispiel sind sowohl die y-Feldwaben 541 als auch die x-Feldwaben 549 mit den entsprechenden Mikrozylinderlinsen 537 und 545 auf jeweils einer Platte integriert. Eine Alternative ist auch, nur die y-Feldwaben oder nur die x-Feldwaben mit den Mikrozylinderlinsen einstückig aufzubauen.

Nach den Mikrozylinderlinsen-Feldwaben-Platten 571 und 573 sind neben der Blendeneinrichtung 514 zwei weitere Blendeneinrichtungen 542 und 550 angeordnet. Durch das Zusammenwirken der Blendeneinrichtungen 542 und 550 ist es möglich die Feldwaben so abzudecken, daß nur vollständig ausgeleuchtete optische Kanäle zum Einsatz kommen. Deshalb sind die Bereiche der x- Feldwaben 549 und y-Feldwaben 541, die in die Bildebene 519 des Beleuchtungssystems abgebildet werden, in ihrer ganzen Breite ausgeleuchtet, wodurch die Uniformität der Feldausleuchtung verbessert wird. Während mit den Blendeneinrichtungen 542 und 550 die optischen Kanäle ausgewählt werden, wird mit der Blendeneinrichtung 514 die Ausleuchtung der Blendenebene entsprechend dem vorgegebenen Beleuchtungsmodus begrenzt.

Ausführungsbeispiel 3:

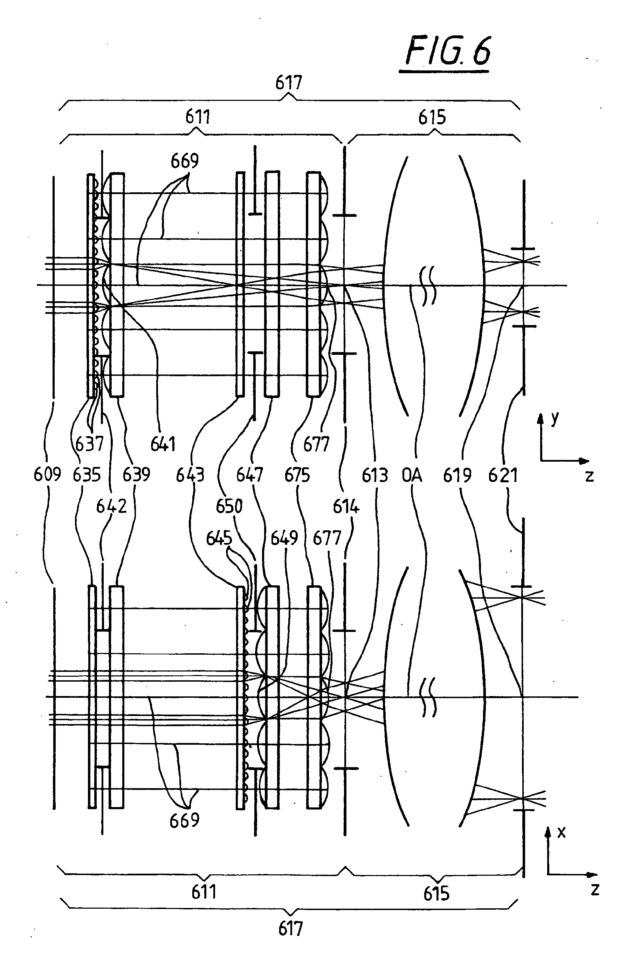

Fig. 6 zeigt ein drittes Ausführungsbeispiel für ein Wabenkondensor-Feldlinse-Modul 617 in schematischer Darstellung. Die obere Darstellung zeigt eine Seitenansicht (y-z-Schnitt), die untere Darstellung eine Draufsicht (x-y-Schnitt). Die den Elementen von Figur 2 entsprechenden Elemente in Figur 6 haben die gleichen Bezugszeichen wie in Figur 2 vermehrt um die Zahl 400. Für eine Beschreibung dieser Elemente wird auf die Beschreibung zu Figur 2 verwiesen.

Das dritte Ausführungsbeispiel weist an Stelle der Platte 251 mit den y-Pupillenwaben 253 und der Platte 255 mit den x-Pupillenwaben 257 eine Platte 675 mit torischen Pupillenwaben 677 auf. Die torischen Pupillenwaben 677 haben sowohl im x- wie auch im y-Schnitt eine sammelnde Wirkung. Die Brennweite im x-Schnitt ist an die Brennweite der x-Feldwaben 649, die Brennweite im y-Schnitt an die Brennweite der y-Feldwaben 641 angepaßt. Die Anpassung der x- und y-Brennweite der torischen Pupillenwaben 677 erfolgt dabei derart, daß sich sowohl der hintere meridionale Brennpunkt als auch der hintere sagittale Brennpunkt des aus y-Feldwabe 641, x-Feldwabe 649 und torischer Pupillenwabe 677 gebildeten Kanals in der Blendenebene 613, der vordere meridionale Brennpunkt dieses Kanals am Ort der y-Feldwaben 641, der vordere sagittale Brennpunkt dieses Kanals am Ort der x-Feldwaben 649 befindet.

In Ausführungsbeispiel 3 ist die Höhe der torischen Pupillenwabe 677 im y-z-Schnitt gleich der Breite $b_1$ der y-Feldwaben 641, die Breite der torischen Pupillenwaben 677 im x-z-Schnitt gleich der Breite $b_2$ der x-Feldwaben 649.

Vor den Platten 639 und 647 mit Feldwaben sind zwei Blendeneinrichtungen 642 und 540 angeordnet, welche die gleiche Funktion erfüllen wie die Blendeneinrichtungen 542 und 550 im zweiten Ausführungsbeispiel.

Ausführungsbeispiel 4:

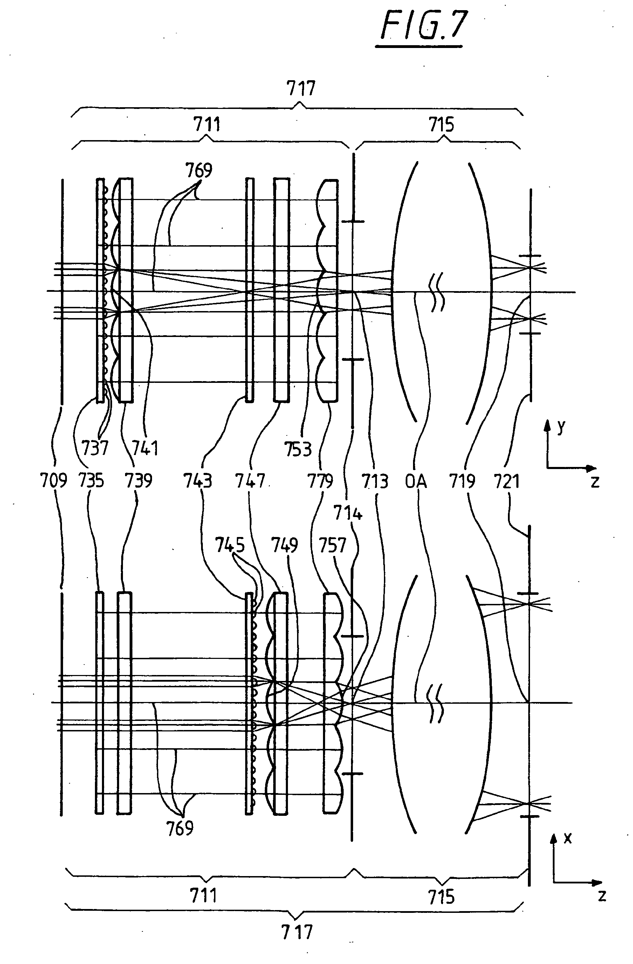

Fig. 7 zeigt ein viertes Ausführungsbeispiel für ein Wabenkondensor-Feldlinse-Modul 717 in schematischer Darstellung. Die obere Darstellung zeigt eine Seitenansicht (y-z-Schnitt), die untere Darstellung eine Draufsicht (x-y-Schnitt). Die den Elementen von Figur 2 entsprechenden Elemente in Figur 7 haben die gleichen Bezugszeichen wie in Figur 2 vermehrt um die Zahl 500. Für eine Beschreibung dieser Elemente wird auf die Beschreibung zu Figur 2 verwiesen.

Im vierten Ausführungsbeispiel sind die y-Pupillenwaben 653 und die x-Pupillenwaben 657 auf einer Platte 679 integriert. Dadurch lassen sich insgesamt zwei Grenzflächen einsparen und die damit verbundenen Transmissionsverluste reduzieren. Die Platte 251 mit den y-Pupillenwaben 253 wie auch die Platte 255 mit den x-Pupillenwaben 257 in Figur 2 weisen jeweils eine plane Fläche auf. Durch Aneinanderfügen dieser planen Flächen fallen die Grenzflächen weg. Neben dem Verbinden der beiden Platten über eine Kittfläche oder durch Ansprengen zu einer Platte 679 ist auch die Strukturierung der Vorderfläche der Platte 679 mit den y-Pupillenwaben 653 und der Rückfläche mit den x-Pupillenwaben 657 realisierbar.

Ausführungsbeispiel 5:

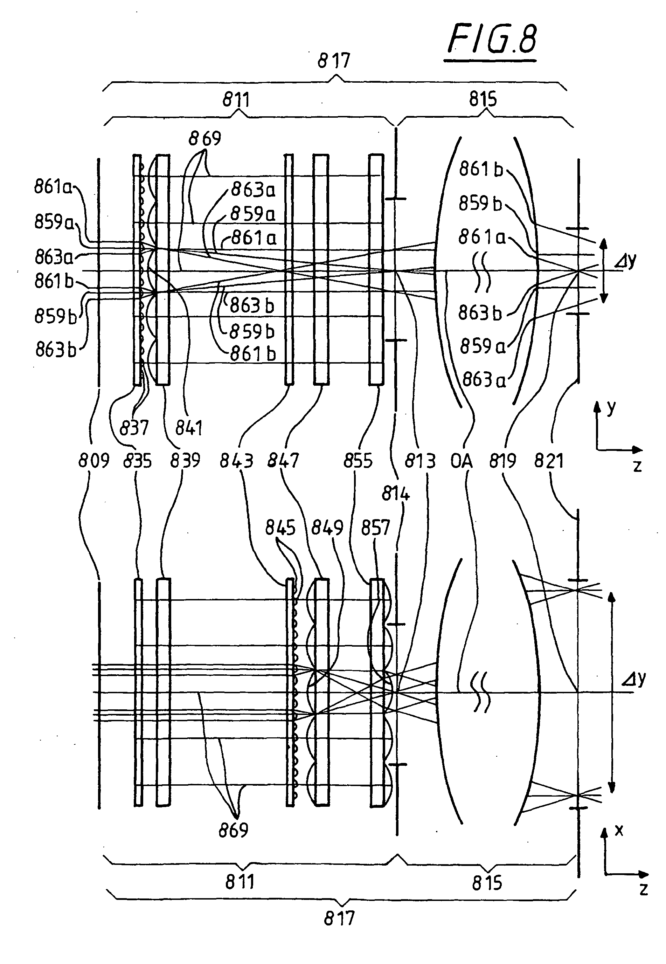

Fig. 8 zeigt ein fünftes Ausführungsbeispiel für ein Wabenkondensor-Feldlinse-Modul 817 in schematischer Darstellung. Die obere Darstellung zeigt eine Seitenansicht (y-z-Schnitt), die untere Darstellung eine Draufsicht (x-y-Schnitt). Die den Elementen von Figur 2 entsprechenden Elemente in Figur 8 haben die gleichen Bezugszeichen wie in Figur 2 vermehrt um die Zahl 600. Für eine Beschreibung dieser Elemente wird auf die Beschreibung zu Figur 2 verwiesen.

Der Aufbau des fünften Ausführungsbeispiels entspricht dem Aufbau des ersten Ausführungsbeispiels der Fig. 2 bis auf die fehlende Platte 251 mit y-Pupillenwaben 253. Ohne die y-Pupillenwaben 253 wird die Ausleuchtung in der Feldebene verbreitert, da die y-Feldwaben 841 nicht mehr randscharf abgebildet werden.

Im folgenden wird die Abbildung der auf der optischen Achse liegenden zentralen y-Feldwabe 841 im y-z-Schnitt betrachtet. Die Achse des aus y-Feldwabe 841, x-Feldwabe 849 und x-Pupillenwabe 857 gebildeten optischen Kanals fällt deshalb mit der optischen Achse OA des Wabenkondensors 811 zusammen. Da sich die Blendenebene 813 im hinteren Brennpunkt des optischen Kanals befindet, werden die Strahlpaare 859a-b, 861a-b und 863a-b in die Blendenebene fokussiert. Die Foki für die von den Strahlpaaren 861a-b und 863a-b begrenzten Strahlbüschel befindet sich dabei jeweils am Rand des optischen Kanals in der Blendenebene. Die Schwerstrahlen der von den Strahlpaaren 861a-b und 863a-b begrenzten Strahlbüschel verlaufen dabei in der Blendenebene 813 nicht parallel zur Achse des optischen Kanals, wie das in Ausführungsbeispiel 1 mit y-Pupillenwaben 253 der Fall war, sondern von der Achse 869 des optischen Kanals weg. Während die Winkeldifferenz der Strahlpaare 859a-b, 861a-b und 863a-b in der Blendenebene 813 gleich groß ist, ist die Schwerstrahlrichtung der von den Strahlpaaren 861a-b und 863a-b begrenzten Strahlenbüschel vom Ort in der Blendenebene 813 abhängig. Daher treten am Rand der optischen Kanäle in der Blendenebene 813 höhere Schwerstrahlwinkel bezüglich der Achsen 869 der optischen Kanäle auf wie auf den Achsen 869 der optischen Kanäle. Diese höheren Strahlwinkel führen nach der Feldlinse 815 in der Feldebene 819 im Vergleich zu einem Aufbau mit y-Pupillenwaben 253 zu einer Verbreiterung der Ausleuchtung. Die Ausdehnung $\Delta y$ der Ausleuchtung ist dabei durch die maximal in der Blendenebene 813 auftretenden Strahlwinkel bezüglich der optischen Achse OA bestimmt.

Die Strahlen 863a und 861b mit den maximalen Strahlwinkeln bezüglich der optischen Achse in der Blendenebene 813 verlaufen im fünften Ausführungsbeispiel durch den oberen, beziehungsweise unteren Rand des ausgeleuchteten Bereichs der einzelnen optischen Kanäle in der Blendenebene 813. Die Strahlen 861b und 863a treffen nach Propagation durch die Feldlinse 815 auf den oberen und unteren Rand des ausgeleuchteten Feldes in der Feldebene 819. Der oberste Objektpunkt in der Feldebene 819 wird von Strahlen beleuchtet, die vom jeweiligen oberen Rand der einzelnen optischen Kanäle kommen. Der Schwerstrahl dieses Strahlenbüschels entspricht dabei Strahl 861b und läuft konvergent auf die optische Achse OA zu.. Der unterste Objektpunkt in der Feldebene 819 wird von Strahlen beleuchtet, die vom jeweiligen unteren Rand der einzelnen optischen Kanäle kommen. Der Schwerstrahl dieses Strahlenbüschels entspricht dabei Strahl 863a und läuft konvergent auf die optische Achse OA zu. Die Pupillenausleuchtung in der Feldebene 819 ist deshalb nicht mehr telezentrisch. Zum Feldrand hin verschiebt sich der Schwerstrahlwinkel, der den Schwerpunkt der Pupillenausleuchtung angibt, entsprechend der Ausdehnung der y-Feldwaben 841, beziehungsweise der optischen Kanäle.

Betrachtet man die von einem Objektpunkt auf den y-Feldwaben ausgehenden Strahlen 859a, 861a und 863a oder 859b, 861b und 863b, so werden diese nicht mehr in die Feldebene 819 fokussiert. Die y-Feldwaben 841 werden nicht mehr in die Feldebene 819 abgebildet. Die Intensitätsverteilung des Rechteckfeldes ist deshalb in einem Schnitt entlang der y-Achse nicht mehr stufenförmig, sondern weist am Rand einen Übergangsbereich auf, in dem die Intensität linear abfällt.

Das fünfte Ausführungsbeispiel in Fig. 8 zeigt den Extremfall, bei dem die Intensitätsverteilung des Rechteckfeldes in einem Schnitt entlang der y-Achse dreickförmig ist. Die Intensität steigt von beiden Seiten der optischen Achse linear von Null bis zu einem Maximum an, das auf der optischen Achse OA liegt. Die Breite $\Delta y$ der Ausleuchtung ist dabei genau doppelt so groß wie mit dem Einsatz von y-Pupillenwaben 253. Dies ist dann der Fall, wenn die Strahlpaare 861a-b und 863a-b unter dem maximal möglichen Auftreffwinkel auf die y-Feldwabe treffen, so daß sie in der Blendenebene auf den Rand des jeweiligen optischen Kanals fokussiert werden. Werden die Strahlpaare nicht auf den Rand des jeweiligen optischen Kanals fokussiert, sondern befinden sich zwischen der Achse und dem Rand des optischen Kanals, so steigt die Intensität in der Feldebene in einem Schnitt entlang der y-Achse linear auf ein Plateau an, in dem die Intensität konstant ist.

Eine Intensitätsverteilung, wie sie sich für das fünfte Ausführungsbeispiel ergibt, ist für ein Scanner-Beleuchtungssystem ausreichend. Die x-Feldwaben und x-Pupillenwaben erzeugen in x-Richtung einen konstanten Intensitätsverlauf. In y-Richtung, die in diesem Fall die Scan-Richtung ist, ergibt sich ein ortsabhängiger Verlauf. Bei Scanner-Systemen ist nur die Scan-Energie von Bedeutung, die sich als Linienintegral in Scan-Richtung über die Intensitätsverteilung ergibt und aufgrund des konstanten Intensitätsverlaufs in x-Richtung für jeden Objektpunkt in der Feldebene 819 nahezu gleich groß ist.

Ausführungsbeispiel 6:

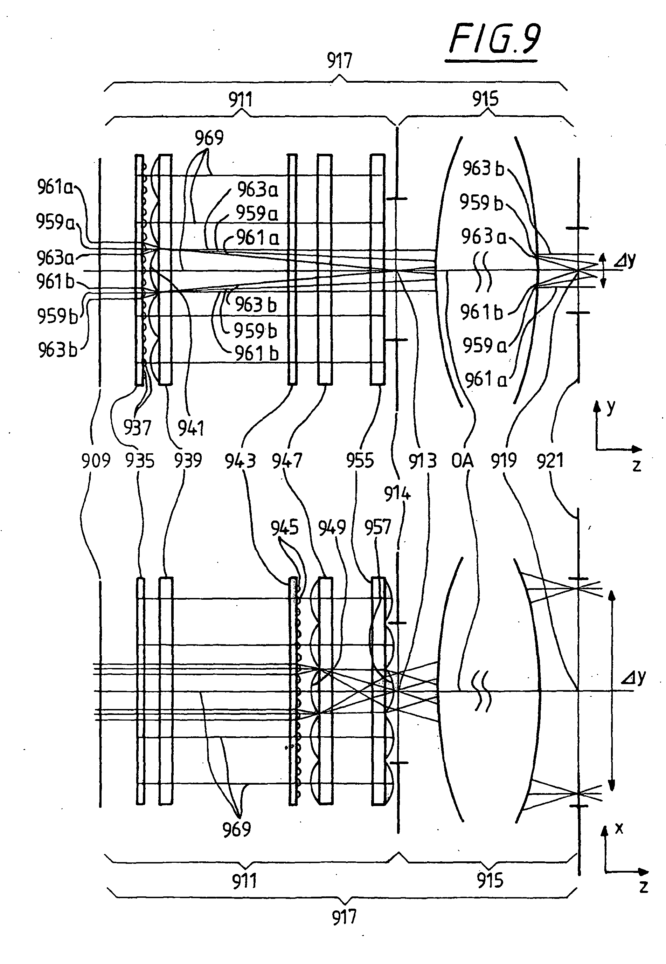

Fig. 9 zeigt ein sechstes Ausführungsbeispiel für ein Wabenkondensor-Feldlinse-Modul 917 in schematischer Darstellung. Die obere Darstellung zeigt eine Seitenansicht (y-z-Schnitt), die untere Darstellung eine Draufsicht (x-y-Schnitt). Die den Elementen von Figur 2 entsprechenden Elemente in Figur 9 haben die gleichen Bezugszeichen wie in Figur 2 vermehrt um die Zahl 700. Für eine Beschreibung dieser Elemente wird auf die Beschreibung zu Figur 2 verwiesen.

Der Aufbau des sechsten Ausführungsbeispiels entspricht dem Aufbau des fünften Ausführungsbeispiels, mit dem Unterschied, daß sich der hintere meridionale Brennpunkt des aus y-Feldwabe 941, x-Feldwabe 949 und x-Pupillenwabe 957 gebildeten optischen Kanals nicht mehr in der Blendenebene 913 befindet. Die optische Wirkung und die Anordnung der y-Feldwaben 941 sind so bestimmt, daß die Strahlen 961a und 963b mit maximalem Strahlwinkel bezüglich der optischen Achse in der Blendenebene die Blendenebene 913 auf der Achse 969 des jeweiligen optischen Kanals schneiden. Dies ist dann der Fall, wenn der Abstand der Blendenebene 913 zum hinteren meridionalen Brennpunkt des optischen Kanals gleich der halben meridionalen Brennweite ist. Propagiert man die Strahlen 961a und 963b durch die Feldlinse 915 in die Feldebene 919, so treffen sie auf den oberen und unteren Rand des ausgeleuchteten Feldes und verlaufen parallel zur optischen Achse OA. Die Strahlen 961a und 963b stellen dabei gleichzeitig die Schwerstrahlen der auf den obersten und untersten Rand treffenden Strahlenbüschel dar, so daß die Feldebene telezentrisch beleuchtet wird. Auch die anderen Punkte in der Feldebene 919 werden telezentrisch beleuchtet. Da jedoch die Winkelverteilung in der Blendenebene 913 innerhalb eines optischen Kanals ortsabhängig ist, nimmt die Intensitätsverteilung zum Feldrand in y-Richtung hin ab. Wird in der Blendenebene 913 jeder optische Kanal vollständig ausgeleuchtet, so ergibt sich im y-Schnitt in der Feldebene 919 ein dreicksförmiger Intensitätsverlauf, wobei die Breite $\Delta y$ der Ausleuchtung doppelt so groß ist wie beim Einsatz von y-Pupillenwaben 253. Bei nicht vollständiger Ausleuchtung steigt der Intensitätsverlauf linear vom Feldrand bis zu einem Plateau an, innerhalb dessen der Intensitätsverlauf konstant ist.

Tabelle 3

| Element | Bezugszeichen | $R_x$ [mm] | $R_y$ [mm] | d [mm] | Glas | B [mm] | f [mm] |
|---|---|---|---|---|---|---|---|
| y-Mikrozylinderlinse | 1 | $\infty$ | 3,627 | 0,503 | CaF$_2$ | 0,30 | 6,50 |
| | 2 | $\infty$ | $\infty$ | 9,959 | | 0,30 | |
| y-Feldwabe | 3 | $\infty$ | 48,500 | 2,041 | CaF$_2$ | 4,00 | 86,92 |
| | 4 | $\infty$ | $\infty$ | 17,562 | | 4,00 | |
| x-Mikrozylinderlinse | 5 | 0,669 | $\infty$ | 0,517 | CaF$_2$ | 0,30 | 1,20 |
| | 6 | $\infty$ | $\infty$ | 27,673 | | 0,30 | |
| x-Feldwabe | 7 | 8,915 | $\infty$ | 2,227 | CaF$_2$ | 4,00 | 15,98 |
| | 8 | $\infty$ | $\infty$ | 11,000 | | 4,00 | |
| x-Pupillenwabe | 9 | $\infty$ | $\infty$ | 2,251 | CaF$_2$ | 4,00 | 14,51 |
| | 10 | -8,099 | $\infty$ | 1,749 | | 4,00 | |
| Blendenebene | 11 | $\infty$ | $\infty$ | | | | |

In Tabelle 3 sind die optischen Daten für den Wabenkondensor gemäß dem sechsten Ausführungsbeispiel für eine Arbeitswellenlänge von $\lambda$ = 157.6 nm angegeben. Die Flächennummern geben die Reihenfolge der Flächen in Lichtrichtung wieder. Fläche 1 entspricht der planen Vorderfläche der Platte 935 mit den y-Mikrozylinderlinsen 937.

Fläche 10 entspricht der Blendenebene 913.Die Breiten b sind dabei die Breiten der Zylinderlinsen senkrecht zu den jeweiligen Zylinderachsen. Die Brennweiten f beziehen sich auf die einzelnen Komponenten. Die Länge der Mikrozylinderlinsen, der Feldwaben und der Pupillenwaben beträgt 120 mm. Dabei sind auf einer Platte 400 Mikrozylinderlinsen, beziehungsweise 30 Feldwaben oder 30 Pupillenwaben angeordnet. Der Durchmesser des auf das Wabenkondensor-Feldlinse-Moduls treffenden parallelen Strahlbüschels beträgt 100 mm.

Die Divergenz der Strahlen innerhalb des Strahlbüschels an der Eintrittsfläche des Wabenkondensors beträgt maximal $\pm$ 25 mrad.

Für den Füllgrad $\eta_x$ jedes optischen Kanals in x-Richtung erhält man

$$\eta_x = \frac{b_4}{b_2} \cdot \frac{f_2}{f_4} = 1.0.$$

Die vorgestellten Ausführungsbeispiele lassen sich insbesondere für Beleuchtungssysteme anwenden, die ein hohes Seiten-Aspektverhältnis des auszuleuchtenden Feldes und Arbeitswellenlängen im VUV, wie beispielsweise 193nm, 157nm oder 126nm aufweisen. Bei diesen Wellenlängen ist die Absorption im Material beträchtlich, so daß als Mischelement ein Wabenkondensor einem totalreflektierendem Glasstab bezüglich der Transmissionsverluste vorzuziehen ist. Durch die Aufspaltung der Wabenplatten in Arrays mit senkrecht zueinander angeordneten Zylinderlinsen lassen sich auch Felder mit hohem Aspektverhältnis bei einfach herzustellenden Komponenten ausleuchten. Dabei wurde zum ersten Mal gezeigt, wie durch den Einsatz von Mikrozylinderlinsen bei dieser Art von Wabenkondensoren die Blendenebene nahezu vollständig ausgeleuchtet werden kann.

**Patentansprüche**

1. Beleuchtungssystem einer Mikrolithographie-Projektionsbelichtungsanlage mit

    - einer Lichtquelle (1),
    - einem ersten Objektiv (3, 5, 7),
    - einem Wabenkondensor (11; 211; 511; 611; 711; 811; 911), der von dem ersten Objektiv (3,5, 7) beleuchtet wird, eine Vielzahl von Strahlenbüscheln erzeugt und

        • ein erstes eindimensionales Array (39; 239; 639; 739; 839; 939) erster Zylinderlinsen (241; 641; 741; 841; 941) mit ersten Zylinderachsen sowie
        • ein zweites eindimensionales Array (47; 247; 647; 747; 847; 947) zweiter Zylinderlinsen (249; 649; 749; 849; 949) mit zweiten Zylinderachsen umfaßt, wobei die zweiten Zylinderachsen senkrecht zu den ersten Zylinderachsen ausgerichtet sind,

    - einer Blendenebene (13; 213; 513; 613; 713; 813; 913) unmittelbar nach dem Wabenkondensor (11; 211; 511; 611; 711; 811; 911),
    - einer Kondensoroptik (15; 215; 515; 615; 715; 815; 915), welche die von dem Wabenkondensor (11; 211; 511; 611; 711; 811; 911) erzeugten Strahlbüschel in einer Bildebene (19; 219; 519; 619; 719; 819; 919) überlagert, um ein Feld auszuleuchten,

    **dadurch gekennzeichnet,**
    **daß** vor dem ersten Array (39; 239; 539; 639; 739; 839; 939) ein Divergenz erhöhendes drittes eindimensionales Array (35; 235; 535; 635; 735; 835; 935) dritter Zylinderlinsen (237; 537; 637; 737; 837; 937) mit dritten Zylinderachsen angeordnet ist,
    wobei die dritten Zylinderachsen parallel zu den ersten Zylinderachsen ausgerichtet sind,
    und **daß** vor dem zweiten Array (47; 247; 547; 647; 747; 847; 947) ein Divergenz erhöhendes viertes eindimensionales Array (43; 243; 543; 643; 743; 843; 943) vierter Zylinderlinsen (245; 545; 645; 745; 845; 945) mit vierten Zylinderachsen angeordnet ist,
    wobei die vierten Zylinderachsen parallel zu den zweiten Zylinderachsen ausgerichtet sind.

2. Beleuchtungssystem nach Anspruch 1, wobei die ersten Zylinderlinsen (241; 541; 641; 741; 841; 941) erste Brennweiten und die zweiten Zylinderlinsen (249; 549; 649; 749; 849; 949) zweite Brennweiten aufweisen, und wobei die ersten Brennweiten größer als die zweiten Brennweiten, bevorzugt größer als das eineinhalbfache der zweiten Brennweiten sind.

3.  Beleuchtungssystem nach Anspruch 1 oder 2, wobei die ersten Zylinderlinsen (241; 541; 641; 741; 841; 941) erste Breiten und die zweiten Zylinderlinsen (249; 549; 649; 749; 849; 949) zweite Breiten aufweisen, und wobei die ersten Breiten gleich der zweiten Breiten sind.

4.  Beleuchtungssystem nach einem der Ansprüche 1 bis 3, wobei die dritten Zylinderlinsen (237; 537; 637; 737; 837; 937) dritte Breiten und die vierten Zylinderlinsen (245; 545; 645; 745; 845; 945) vierte Breiten aufweisen, und wobei die ersten Breiten mindestens das doppelte, bevorzugt mindestens das fünffache der dritten Breiten, und wobei die zweiten Breiten mindestens das doppelte, bevorzugt mindestens das fünffache der vierten Breiten betragen.

5.  Beleuchtungssystem nach einem der Ansprüche 1 bis 4, wobei die dritten Breiten gleich der vierten Breiten sind.

6.  Beleuchtungssystem nach einem der Ansprüche 1 bis 5, wobei die dritten Zylinderlinsen (237; 537; 637; 737; 837; 937) dritte Brennweiten und die vierten Zylinderlinsen (245; 545; 645; 745; 845; 945) vierte Brennweiten aufweisen, und
    wobei das Breite-Brennweite-Verhältnis der dritten Zylinderlinsen (237; 537; 637; 737; 837; 937) kleiner als dasjenige der ersten Zylinderlinsen (241; 641; 741; 841; 941) ist, und/oder wobei das Breite-Brennweite-Verhältnis der vierten Zylinderlinsen (245; 545; 645; 745; 845; 945) kleiner als dasjenige der zweiten Zylinderlinsen (249; 649; 749; 849; 949) ist.

7.  Beleuchtungssystem nach Anspruch 6, wobei das Breite-Brennweite-Verhältnis der dritten Zylinderlinsen (237; 537; 637; 737; 837; 937) mindestens die Hälfte desjenigen der ersten Zylinderlinsen (241; 641; 741; 841; 941) beträgt, und/oder wobei das Breite-Brennweite-Verhältnis der vierten Zylinderlinsen (245; 545; 645; 745; 845; 945) mindestens die Hälfte desjenigen der zweiten Zylinderlinsen (249; 649; 749; 849; 949) beträgt.

8.  Beleuchtungssystem nach einem der Ansprüche 1 bis 7, wobei die dritten Zylinderlinsen (537) auf einer Vorderfläche und die ersten Zylinderlinsen (541) auf einer Rückfläche einer einstückigen Platte (571) und/oder die vierten Zylinderlinsen (545) auf einer Vorderfläche und die zweiten Zylinderlinsen (549) auf einer Rückfläche einer einstückigen Platte (573) angeordnet sind.

9.  Beleuchtungssystem nach einem der Ansprüche 1 bis 8, wobei die Blendenebene (13; 213; 513; 613; 713; 813; 913) zugänglich ist.

10. Beleuchtungssystem nach Anspruch 9, wobei in der Blendenebene (13; 213; 513; 613; 713; 813; 913) eine erste Blendeneinrichtung (14; 214; 514; 614; 714; 814; 914) zur Steuerung einer Ausleuchtung der Blendenebene (13; 213; 513; 613; 713; 813; 913) angeordnet ist.

11. Beleuchtungssystem nach einem der Ansprüche 1 bis 10, wobei vor oder hinter dem ersten Array (571; 639) eine zweite Blendeneinrichtung (542; 642) und/oder vor oder hinter dem zweiten Array (551; 647) eine dritte Blendeneinrichtung (550; 650) zur Steuerung einer Ausleuchtung der Blendenebene (513; 613) angeordnet ist.

12. Beleuchtungssystem nach einem der Ansprüche 1 bis 11, wobei der Wabenkondensor (611) in der Nähe der Blendenebene (613) ein zweidimensionales Array (675) torischer Linsen (677) aufweist, welche zwei zueinander senkrecht stehende Hauptachsen aufweisen, wobei die eine Hauptachse parallel zu den ersten Zylinderachsen und die andere Hauptachse parallel zu den zweiten Zylinderachsen ausgerichtet ist.

13. Beleuchtungssystem nach Anspruch 12, wobei eine torische Linse (677) zusammen mit einer ersten Zylinderlinse (641) und einer zweiten Zylinderlinse (649) einen optischen Kanal mit einer gemeinsamen geraden Achse (669) bildet und der optische Kanal einen hinteren Brennpunkt aufweist, der sich in der Blendenebene (613) oder in deren Nähe befindet.

14. Beleuchtungssystem nach Anspruch 13, wobei der optische Kanal in einem Schnitt mit einer Ebene, deren Normale in Richtung der ersten Zylinderachsen zeigt und welche die Achse (669) des optischen Kanals enthält, einen meridionalen vorderen Brennpunkt aufweist, der sich am Ort der ersten Zylinderlinse (641) befindet, und wobei der optische Kanal in einem Schnitt mit einer Ebene, deren Normale in Richtung der zweiten Zylinderachsen zeigt und welche die Achse (669) des optischen Kanals enthält, einen sagittalen vorderen Brennpunkt aufweist, der sich am

17

Ort der zweiten Zylinderlinse (649) befindet.

**15.** Beleuchtungssystem nach einem der Ansprüche 1 bis 11, wobei der Wabenkondensor (11; 211; 511; 811; 911) in der Nähe der Blendenebene (13; 213; 513; 813; 913) ein fünftes eindimensionales Array (155; 255; 555; 855; 955) fünfter Zylinderlinsen (257; 557; 857; 957) mit fünften Zylinderachsen aufweist, wobei die fünften Zylinderachsen parallel zu den zweiten Zylinderachsen ausgerichtet sind.

**16.** Beleuchtungssystem nach Anspruch 15, wobei eine fünfte Zylinderlinse (257; 557; 857; 957) zusammen mit einer ersten Zylinderlinse (241; 542; 841; 941) und einer zweiten Zylinderlinse (249; 549; 849; 949) einen optischen Kanal mit einer gemeinsamen Achse (269; 569; 869; 969) bildet, und wobei der optische Kanal in einem Schnitt mit einer Ebene, deren Normale in Richtung der zweiten Zylinderachsen zeigt und welche die Achse (269; 569; 869; 969) des optischen Kanals enthält, einen sagittalen hinteren Brennpunkt aufweist, der sich in der Blendenebene (213; 513; 813; 913) oder in deren Nähe befindet.

**17.** Beleuchtungssystem nach Anspruch 16, wobei der optische Kanal in einem Schnitt mit einer Ebene, deren Normale in Richtung der zweiten Zylinderachsen (249; 549; 849; 949) zeigt und welche die Achse (269; 569; 869; 969) des optischen Kanals enthält, einen sagittalen vorderen Brennpunkt aufweist, der sich am Ort der zweiten Zylinderlinse (249; 549; 849; 949) befindet.

**18.** Beleuchtungssystem nach Anspruch 16 oder 17, wobei der optische Kanal in einem Schnitt mit einer Ebene, deren Normale in Richtung der ersten Zylinderachsen zeigt und die Achse (269; 569; 869) des Kanals enthält, einen meridionalen hinteren Brennpunkt aufweist, der sich in der Blendenebene (213; 513; 813) oder in deren Nähe befindet.

**19.** Beleuchtungssystem nach Anspruch 16 oder 17, wobei der optische Kanal in einem Schnitt mit einer Ebene, deren Normale in Richtung der ersten Zylinderachsen (941) zeigt und die Achse (969) des Kanals enthält, einen meridionalen hinteren Brennpunkt und eine meridionale Brennweite aufweist, und wobei der Abstand zwischen der Blendenebene (913) und dem meridionalen hinteren Brennpunkt nahezu gleich der halben meridionalen Brennweite ist.

**20.** Beleuchtungssystem nach Anspruch 15, wobei der Wabenkondensor (11; 211; 511) ein sechstes eindimensionales Array (251; 551) sechster Zylinderlinsen (253; 553) mit sechsten Zylinderachsen in der Nähe der Blendenebene (13; 213; 513) aufweist, wobei die sechsten Zylinderachsen parallel zu den ersten Zylinderachsen ausgerichtet sind.

**21.** Beleuchtungssystem nach Anspruch 20, wobei eine sechste Zylinderlinse (253; 553) zusammen mit einer fünften Zylinderlinse (257; 557), einer zweiten Zylinderlinse (249; 549) und einer ersten Zylinderlinse (241; 541) einen optischen Kanal mit einer gemeinsamen geraden Achse (269; 569) bildet, und wobei der optische Kanal einen hinteren Brennpunkt aufweist, der sich in der Blendenebene (213; 513) oder in deren Nähe befindet.

**22.** Beleuchtungssystem nach Anspruch 21, wobei der optische Kanal in einem Schnitt mit einer Ebene, deren Normale in Richtung der ersten Zylinderachsen zeigt und welche die Achse (269; 569) des optischen Kanals enthält, einen meridionalen vorderen Brennpunkt aufweist, der sich am Ort der ersten Zylinderlinse (241; 541) befindet, und wobei der optische Kanal in einem Schnitt mit einer Ebene, deren Normale in Richtung der zweiten Zylinderachsen zeigt und welche die Achse (269; 569) des optischen Kanals enthält, einen sagittalen vorderen Brennpunkt aufweist, der sich am Ort der zweiten Zylinderlinse (249; 549) befindet.

**23.** Beleuchtungssystem nach einem der Ansprüche 20 bis 22, wobei die ersten Zylinderlinsen (241; 541), die zweiten Zylinderlinsen (249; 549), die fünften Zylinderlinsen (257; 557) und die sechsten Zylinderlinsen (253; 553) die gleiche Breite aufweisen.

**24.** Beleuchtungssystem nach Anspruch 23, wobei der Wabenkondensor (211) zusammen mit dem dritten Array (235) und dem vierten Array (243) die Blendenebene (213) ausleuchtet, wobei die Ausleuchtung (400) der Blendenebene unbeleuchtete erste Streifen (406) in Richtung der ersten Zylinderachsen im Abstand der ersten Breite aufweist, und wobei die Breite der ersten Streifen (406) maximal 20% der ersten Breite beträgt, und wobei die Ausleuchtung der Blendenebene unbeleuchtete zweite Streifen (404) in Richtung der zweiten Zylinderachsen im Abstand der zweiten Breite aufweist, und wobei die Breite der zweiten Streifen (404) maximal 20% der zweiten Breite beträgt.

**25.** Beleuchtungssystem nach Anspruch 24, wobei die Breite der ersten Streifen (406) gleich der Breite der zweiten Streifen (404) ist.

26. Beleuchtungssystem nach einem der Ansprüche 20 bis 25, wobei die fünften Zylinderlinsen (257; 557) auf einer Vorderfläche und die sechsten Zylinderlinsen (253; 553) auf einer Rückfläche einer einstückigen Platte (779) angeordnet sind.

27. Beleuchtungssystem einer Mikrolithographie-Projektionsbelichtungsanlage mit

   - einer Lichtquelle (1),
   - einem ersten Objektiv (3, 5, 7),
   - einem Wabenkondensor (11; 811; 911), der von dem ersten Objektiv (3, 5, 7) beleuchtet wird, eine Vielzahl von Strahlenbüscheln erzeugt und

   • ein erstes eindimensionales Array (839; 939) erster Zylinderlinsen (841; 941) mit ersten Zylinderachsen sowie
   • ein zweites eindimensionales Array (847; 947) zweiter Zylinderlinsen (849; 949) mit zweiten Zylinderachsen umfasst, wobei die zweiten Zylinderachsen senkrecht zu den ersten Zylinderachsen ausgerichtet sind,

   - einer Blendenebene (13; 813; 913) unmittelbar nach dem Wabenkondensor (11; 811; 911),
   - einer Kondensoroptik (15; 815; 915), welche die von dem Wabenkondensor (11; 811; 911) erzeugten Strahlenbüschel in einer Bildebene (19; 819; 919) überlagert, um ein Feld auszuleuchten, **dadurch gekennzeichnet,**

   **dass** die Mikrolithographie-Projektionsbelichtungsanlageein Scanner mit einer Scannrichtung ist, und
   **dass** der Wabenkondensors (11; 811; 911) in der Nähe der Blendenebene (13; 813: 913) nur ein fünftes eindimensionales Array (855; 955) fünfter Zylinderlinsen (857; 957) mit fünften Zylinderachsen aufweist, und die fünften Zylinderachsen parallel zu den zweiten Zylinderachsen und parallel zur Spannrichtung ausgerichtet sind.

28. Beleuchtungssystem nach Anspruch 27, wobei eine fünfte Zylinderlinse (857; 957) zusammen mit einer ersten Zylinderlinse (841; 941) und einer zweiten Zylinderlinse (849; 949) einen optischen Kanal mit einer gemeinsamen Achse (869; 969) bildet, und wobei der optische Kanal in einem Schnitt mit einer Ebene, deren Normale in Richtung der zweiten Zylinderachsen zeigt und welche die Achse (869; 969) des optischen Kanals enthält, einen sagittalen hinteren Brennpunkt aufweist, der sich in der Blendenebene (813; 913) oder in deren Nähe befindet.

29. Beleuchtungssystem nach Anspruch 28, wobei der optische Kanal in einem Schnitt mit einer Ebene, deren Normale in Richtung der zweiten Zylinderachsen zeigt und welche die Achse (869; 969) des optischen Kanals enthält, einen sagittalen vorderen Brennpunkt aufweist, der sich am Ort der zweiten Zylinderlinse (849; 949) befindet.

30. Beleuchtungssystem nach Anspruch 28 oder 29, **dadurch gekennzeichnet**, wobei der optische Kanal in einem Schnitt mit einer Ebene, deren Normale in Richtung ersten Zylinderachsen zeigt und die Achse (869) des Kanals enthält, einen meridionalen hinteren Brennpunkt aufweist, der sich in der Blendenebene (813) oder in deren Nähe befindet.

31. Beleuchtungssystem nach Anspruch 28 oder 29, wobei der optische Kanal in einem Schnitt mit einer Ebene, deren Normale in Richtung der ersten Zylinderachsen zeigt und die Achse (969) des Kanals enthält, einen meridionalen hinteren Brennpunkt und eine meridionale Brennweite aufweist, und wobei der Abstand zwischen der Blendenebene (913) und dem meridionalen hinteren Brennpunkt nahezu gleich der halben meridionalen Brennweite ist.

32. Beleuchtungssystem nach einem der Ansprüche 27 bis 31, **dadurch gekennzeichnet, dass** vor dem ersten Array (839; 939) ein divergerizerhöhendes drittes eindimensionales Array (835; 935) dritter Zylinderlinsen (837; 937) mit dritten Zylinderachsen angeordnet ist, wobei die dritten Zylinderachsen parallel zu den ersten Zylinderachsen ausgerichtet sind.

33. Beleuchtungssystem nach einem der Ansprüche 27 bis 32, **dadurch gekennzeichnet, dass** vor dem zweiten Array (847; 947) ein divergenzerhöhendes viertes eindimensionales Array (843; 943) vierter Zylinderlinsen (845; 945) mit vierten Zylinderachsen angeordnet ist, wobei die vierten Zylinderachsen parallel zu den zweiten Zylinderachsen ausgerichtet sind.

34. Mikrolithographie-Projektionsbeuchtungsanlage

- mit einem Beleuchtungssystem (1, 3, 5, 7, 9, 11, 13, 14, 15, 17, 19, 21, 23, 25) nach einem der Ansprüche 1-33.
- mit einer Maske (27) auf einem ersten Trägersystem,
- mit einem Projektionsobjektiv (29),

mit einem lichtempfindlichen Substrat (33) auf einem zweiten Trägersystem.

35. Verfahren zur Herstellung mikrostrukturierter Bauteile, bei dem ein mit einer lichtempfindlichen Schicht versehenes Substrat (33) mittels einer Maske (27) und einer Mikrolithographie-Projektionsbelichtungsanlage nach Anspruch 34 belichtet wird und mittels einer Abbildung eines auf der Maske (27) enthaltenen Musters strukturiert wird.

**Claims**

1. Illumination system of a microlithography projection exposure apparatus, having

   - a light source (1),
   - a first objective (3, 5, 7),
   - a honeycomb condenser (11; 211; 511; 611; 711; 811; 911) which is illuminated by the first objective (3, 5, 7), generates a multiplicity of ray bundles and

     • comprises a first one-dimensional array (39; 239; 639; 739; 839; 939) of first cylinder lenses (241; 641; 741; 841; 941) with first cylinder axes and
     • a second one-dimensional array (47; 247; 647; 747; 847; 947) of second cylinder lenses (249; 649; 749; 849; 949) with second cylinder axes, the second cylinder axes being aligned perpendicularly to the first cylinder axes,

   - a diaphragm plane (13; 213; 513; 613; 713; 813; 913) immediately after the honeycomb condenser (11; 211; 511; 611; 711; 811; 911),
   - condenser optics (15; 215; 515; 615; 715; 815; 915) which superimpose the ray bundles generated by the honeycomb condenser (11; 211; 511; 611; 711; 811; 911) in an image plane (19; 219; 519; 619; 719; 819; 919), in order to illuminate a field,

   **characterized in that**
   a divergence-increasing third one-dimensional array (35; 235; 535; 635; 735; 835; 935) of third cylinder lenses (237; 537; 637; 737; 837; 937) with third cylinder axes is arranged before the first array (39; 239; 539; 639; 739; 839; 939), the third cylinder lenses being aligned parallel to the first cylinder axes,
   and **in that** a divergence-increasing fourth one-dimensional array (43; 243; 543; 643; 743; 843; 943) of fourth cylinder lenses (245; 545; 645; 745; 845; 945) with fourth cylinder axes is arranged before the second array (47; 247; 547; 647; 747; 847; 947),
   the fourth lenses being aligned parallel to the second cylinder axes.

2. Illumination system according to Claim 1, wherein the first cylinder lenses (241; 541; 641; 741; 841; 941) have first focal lengths and the second cylinder lenses (249; 549; 649; 749; 849; 949) have second focal lengths, and wherein the first focal lengths are greater than the second focal lengths, preferably more than one and a half times the second focal lengths.

3. Illumination system according to Claim 1 or 2, wherein the first cylinder lenses (241; 541; 641; 741; 841; 941) have first widths and the second cylinder lenses (249; 549; 649; 749; 849; 949) have second widths, and wherein the first widths are equal to the second widths.

4. Illumination system according to one of Claims 1 to 3, wherein the third cylinder lenses (237; 537; 637; 737; 837; 937) have third widths and the fourth cylinder lenses (245; 545; 645; 745; 845; 945) have fourth widths, and wherein the first widths are at least twice, preferably at least five times the third widths, and where in the second widths are at least twice, preferably at least five times the fourth widths.

5. Illumination system according to one of Claims 1 to 4, wherein the third widths are equal to the fourth widths.

6. Illumination system according to one of Claims 1 to 5, wherein the third cylinder lenses (237; 537; 637; 737; 837;

937) have third focal lengths and the fourth cylinder lenses (245; 545; 645; 745; 845; 945) have fourth focal lengths, and wherein the width-focal length ratio of the third cylinder lenses (237; 537; 637; 737; 837; 937) is less than that of the first cylinder lenses (241; 641; 741; 841; 941), and/or wherein the width-focal length ratio of the fourth cylinder lenses (245; 545; 645; 745; 845; 945) is less than that of the second cylinder lenses (249; 649; 749; 849; 949).

7. Illumination system according to Claim 6, wherein the width-focal length ratio of the third cylinder lenses (237; 537; 637; 737; 837; 937) is at least half that of the first cylinder lenses (241; 641; 741; 841; 941), and/or wherein the width-focal length ratio of the fourth cylinder lenses (245; 545; 645; 745; 845; 945) is at least half that of the second cylinder lenses (249; 649; 749; 849; 949).

8. Illumination system according to one of Claims 1 to 7, wherein the third cylinder lenses (537) are arranged on a front surface and the first cylinder lenses (541) are arranged on a rear surface of a monobloc plate (571) and/or the fourth cylinder lenses (545) are arranged on a front surface and the second cylinder lenses (549) are arranged on a rear surface of a monobloc plate (573).

9. Illumination system according to one of Claims 1 to 8, wherein the diaphragm plane (13; 213; 513; 613; 713; 813; 913) is accessible.

10. Illumination system according to Claim 9, wherein a first diaphragm device (14; 214; 514; 614; 714; 814; 914) is arranged in the diaphragm plane (13; 213; 513; 613; 713; 813; 913) to control an illumination of the diaphragm plane (13; 213; 513; 613; 713; 813; 913).

11. Illumination system according to one of Claims 1 to 10, wherein a second diaphragm device (542; 642) is arranged before or after the first array (571; 639) and/or a third diaphragm device (550; 650) is arranged before or after the second array (551; 647) to control an illumination of the diaphragm plane (513; 613).

12. Illumination system according to one of Claims 1 to 11, wherein a honeycomb condenser (611) in the vicinity of the diaphragm plane (613) comprises a two-dimensional array (675) of toric lenses (677) which have two mutually perpendicular principal axes, one principal axis being aligned parallel to the first cylinder axes and the other principal axis being aligned parallel to the second cylinder axes.

13. Illumination system according to Claim 12, wherein a toric lens (677) together with a first cylinder lens (641) and a second cylinder lens (649) forms an optical channel with a common straight axis (669) and the optical channel has a rear focal point which lies in the diaphragm plane (613) or in its vicinity.

14. Illumination system according to Claim 13, wherein the optical channel in a section with a plane whose normal points in the direction of the first cylinder axes and which contains the axis (669) of the optical channel has a meridianal front focal point which lies at the position of the first cylinder lens (641), and wherein the optical channel in a section with a plane whose normal points in the direction of the second cylinder axes and which contains the axis (669) of the optical channel has a sagittal front focal point which lies at the position of the second cylinder lens (649).

15. Illumination system according to one of Claims 1 to 11, wherein the honeycomb condenser (11; 211; 511; 811; 911) comprises a fifth one-dimensional array (155; 255; 555; 855; 955) of fifth cylinder lenses (257; 557; 857; 957) with fifth cylinder axes in the vicinity of the diaphragm plane (13; 213; 513; 813; 913), the fifth cylinder axes being aligned parallel to the second cylinder axes.

16. Illumination system according to Claim 15, wherein a fifth cylinder lens (257; 557; 857; 957) together with a first cylinder lens (241; 541; 841; 941) and a second cylinder lens (249; 549; 849; 949) forms an optical channel with a common axis (269; 569; 869; 969), and wherein the optical channel in a section with a plane whose normal points in the direction of the second cylinder axes and contains the axis (269; 569; 869; 969) of the optical channel has a sagittal rear focal point which lies in the diaphragm plane (213; 513; 813; 913) or in its vicinity.

17. Illumination system according to Claim 16, wherein the optical channel in a section with a plane whose normal points in the direction of the second cylinder axes (249; 549; 849; 949) and which contains the axis (269; 569; 869; 969) of the optical channel has a sagittal front focal point which lies at the position of the second cylinder lens (249; 549; 849; 949) or in its vicinity.

18. Illumination system according to Claim 16 or 17, wherein the optical channel in a section with a plane whose normal points in the direction of the first cylinder axes and contains the axis (269; 569; 869) of the channel has a meridianal rear focal point which lies in the diaphragm plane (213; 513; 813) or in its vicinity.

19. Illumination system according to Claim 16 or 17, wherein the optical channel in a section with a plane whose normal points in the direction of the first cylinder axes (941) and contains the axis (969) of the channel has a meridianal rear focal point and a meridianal focal length, and wherein the distance between the diaphragm plane (913) and the meridianal rear focal point is approximately equal to half the meridianal focal length.

20. Illumination system according to Claim 15, wherein the honeycomb condenser (11; 211; 511) comprises a sixth one-dimensional array (251; 551) of sixth cylinder lenses (253; 553) in the vicinity of the diaphragm plane (13; 213; 513), the sixth cylinder axes being aligned parallel to the first cylinder axes.

21. Illumination system according to Claim 20, wherein a sixth cylinder lens (253; 553) together with a fifth cylinder lens (257; 557), a second cylinder lens (249; 549) and a first cylinder lens (241; 541) forms an optical channel with a common straight axis (269; 569), and wherein the optical channel has a rear focal point which lies in the diaphragm plane (213; 513) or in its vicinity.

22. Illumination system according to Claim 21, wherein the optical channel in a section with a plane whose normal points in the direction of the first cylinder axes and which contains the axis (269, 569) of the optical channel has a meridianal front focal point which lies at the position of the first cylinder lens (241; 541), and wherein the optical channel in a section with a plane whose normal points in the direction of the second cylinder axes and which contains the axis (269, 569) of the optical channel has a sagittal front focal point which lies at the position of the second cylinder lens (249; 549).

23. Illumination system according to one of Claims 20 to 22, wherein the first cylinder lenses (241; 541) the second cylinder lenses (249; 549), the fifth cylinder lenses (257; 557) and the sixth cylinder lenses (253; 553) have the same width.

24. Illumination system according to Claim 23, wherein a honeycomb condenser (211) together with the third array (235) and the fourth array (243) illuminates the diaphragm plane (213), wherein the illumination (400) of the diaphragm plane comprises unilluminated first strips (406) in the direction of the first cylinder axes with the spacing of the first width, and wherein the width of the first strips (406) is at most 20% of the first width, and wherein the illumination of the diaphragm plane comprises unilluminated second strips (404) in the direction of the second cylinder axes with the spacing of the second width, and wherein the width of the second strips (404) is at most 20% of the second width.

25. Illumination system according to Claim 24, wherein the width of the first strips (406) is equal to the width of the second strips (404).

26. Illumination system according to one of Claims 20 to 25, wherein the fifth cylinder lenses (2,57; 557) are arranged on a front surface and the sixth cylinder lenses (253; 553) are arranged on a rear surface of a monobloc plate (779).

27. Illumination system of a microlithography projection exposure apparatus, having

    - a light source (1),
    - a first objective (3, 5, 7),
    - a honeycomb condenser (11; 811; 911) which is illuminated by the first objective (3, 5, 7), generates a multiplicity of ray bundles and

        • comprises a first one-dimensional array (839; 939) of first cylinder lenses (841; 941) with first cylinder axes and
        • a second one-dimensional array (847; 947) of
        • a second one-dimensional array (847; 947) of second cylinder lenses (849; 949) with second cylinder axes, the second cylinder axes being aligned perpendicularly to the first cylinder axes,

    - a diaphragm plane (13; 813; 913) immediately after the honeycomb condenser (11; 811; 911),
    - condenser optics (15; 815; 915) which superimpose the ray bundles generated by the honeycomb condenser (11; 811; 911) in an image plane (19; 819; 919), in order to illuminate a field,

**characterized in that**
the microlithography projection exposure apparatus is a scanner with a scan direction, and
**in that** the honeycomb condenser (11; 811; 911) in the vicinity of the diaphragm plane (13; 813; 913) has only a fifth one-dimensional array (855; 955) of fifth cylinder lenses (857; 957) with fifth cylinder axes, and the fifth cylinder axes are aligned parallel to the second cylinder axes and parallel to the scan direction.

28. Illumination system according to Claim 27, wherein a fifth cylinder lens (857; 957) together with a first cylinder lens (841; 941) and a second cylinder lens (849; 949) forms an optical channel with a common axis (869; 969), and wherein the optical channel in a section with a plane whose normal points in the direction of the second cylinder axes and which contains the axis (869; 969) of the optical channel has a sagittal rear focal point which lies in the diaphragm plane (813; 913) or in its vicinity.

29. Illumination system according to Claim 28, wherein the optical channel in a section with a plane whose normal points in the direction of the second cylinder axes and which contains the axis (869; 969) of the optical channel has a sagittal front focal point which lies at the position of the second cylinder lens (849; 949).

30. Illumination system according to Claim 28 or 29, wherein the optical channel in a section with a plane whose normal points in the direction of the first cylinder axes and which contains the axis (869) of the channel has a meridianal rear focal point which lies in the diaphragm plane (813) or in its vicinity.

31. Illumination system according to Claim 28 or 29, wherein the optical channel in a section with a plane whose normal points in the direction of the first cylinder axes and which contains the axis (969) of the channel has a meridianal rear focal point and a meridianal focal length, and wherein the distance between the image plane (913) and the meridianal rear focal point is approximately equal to half the meridianal focal length.

32. Illumination system according to one of Claims 27 to 31, **characterized in that** a divergence-increasing third one-dimensional array (835; 935) of third cylinder lenses (837; 937) with third cylinder axes is arranged before the first array (839; 939), the third cylinder axes being aligned parallel to the first cylinder axes.

33. Illumination system according to one of Claims 27 to 32, **characterized in that** a divergence-increasing fourth one-dimensional array (843; 943) of fourth cylinder lenses (845; 945) with fourth cylinder axes is arranged before the second array (847; 947), the fourth lenses being aligned parallel to the second cylinder axes.

34. Microlithography projection exposure apparatus

   - having an illumination system (1, 3, 5, 7, 9, 11, 13, 14, 15, 17, 19, 21, 23, 25) according to one of Claims 1-33,
   - having a mask (27) on a first support system,
   - having a projection objective (29),

   having a photosensitive substrate (33) on a second support system.

35. Method for producing microstructured components, in which a substrate (33) provided with a photosensitive layer is exposed by means of a mask (27) and a microlithography projection exposure apparatus according to Claim 34, and is structured by means of imaging a pattern contained on the mask (27).

**Revendications**

1. Système d'éclairage d'un équipement d'exposition par projection pour microlithographie comprenant

   - une source de lumière (1),
   - un premier objectif (3, 5, 7),
   - un condenseur alvéolaire (11 ; 211 ; 511 ; 611 ; 711 ; 811 ; 911) qui est éclairé par le premier objectif (3, 5, 7), génère une pluralité de faisceaux de lignes et

      * comprend un premier réseau unidimensionnel (39 ; 239 ; 639 ; 739 ; 839 ; 939) de premières lentilles cylindriques (241 ; 641 ; 741 ; 841 ; 941) ayant des premiers axes de cylindre ainsi que
      * un deuxième réseau unidimensionnel (47 ; 247 ; 647 ; 747 ; 847 ; 947) de deuxièmes lentilles cylindriques (249 ; 649 ; 749 ; 849 ; 949) ayant des deuxièmes axes de cylindre, les deuxièmes axes de cylindre étant dirigés perpendiculairement par rapport aux premiers axes de cylindre,

- un plan d'obturation (13 ; 213 ; 513 ; 613 ; 713 ; 813 ; 913) directement après le condenseur alvéolaire (11 ; 211 ; 511 ; 611 ; 711 ; 811 ; 911),
- une optique de condenseur (15 ; 215 ; 515 ; 615 ; 715 ; 815 ; 915) qui superpose les faisceaux de lignes générés par le condenseur alvéolaire (11 ; 211 ; 511 ; 611 ; 711 ; 811 ; 911) dans un plan d'image (19 ; 219 ; 519 ; 619 ; 719 ; 819 ; 919) afin d'éclairer un champ,

**caractérisé en ce que**
un troisième réseau unidimensionnel (35 ; 235 ; 535 ; 635 ; 735 ; 835 ; 935) de troisièmes lentilles cylindriques (237 ; 537 ; 637 ; 737 ; 837 ; 937) ayant des troisièmes axes de cylindre augmentant une divergence est disposé devant le premier réseau (39 ; 239 ; 539 ; 639 ; 739 ; 839 ; 939),
les troisièmes axes de cylindre étant orientés parallèlement aux premiers axes de cylindre,
et un quatrième réseau unidimensionnel (43 ; 243 ; 543 ; 643 ; 743 ; 843 ; 943) de quatrièmes lentilles cylindriques (245 ; 545 ; 645 ; 745 ; 845 ; 945) ayant des quatrièmes axes de cylindre augmentant une divergence est disposé devant le deuxième réseau (47 ; 247 ; 547 ; 647 ; 747 ; 847 ; 947),
les quatrièmes axes de cylindre étant orientés parallèlement aux deuxièmes axes de cylindre.

2. Système d'éclairage selon la revendication 1, les premières lentilles cylindriques (241 ; 541 ; 641 ; 741 ; 841 ; 941) présentant des premières distances focales et les deuxièmes lentilles cylindriques (249 ; 549 ; 649 ; 749 ; 849 ; 949) présentant des deuxièmes distances focales, les premières distances focales étant supérieures aux deuxièmes distances focales, de préférence supérieures à une fois et demi les deuxièmes distances focales.

3. Système d'éclairage selon la revendication 1 ou 2, les premières lentilles cylindriques (241 ; 541 ; 641 ; 741 ; 841 ; 941) présentant des premières largeurs et les deuxièmes lentilles cylindriques (249 ; 549 ; 649 ; 749 ; 849 ; 949) présentant des deuxièmes largeurs, les premières largeurs étant égales aux deuxièmes largeurs.

4. Système d'éclairage selon l'une des revendications 1 à 3, les troisièmes lentilles cylindriques (237 ; 537 ; 637 ; 737 ; 837 ; 937) présentant des troisièmes largeurs et les quatrièmes lentilles cylindriques (245 ; 545 ; 645 ; 745 ; 845 ; 945) présentant des quatrièmes largeurs, les premières largeurs étant égales au moins au double, de préférence au moins au quintuple des troisièmes largeurs et les deuxièmes largeurs étant égales au moins au double, de préférence au moins au quintuple des quatrièmes largeurs.

5. Système d'éclairage selon l'une des revendications 1 à 4, les troisièmes largeurs étant égales aux quatrièmes largeurs.

6. Système d'éclairage selon l'une des revendications 1 à 5, les troisièmes lentilles cylindriques (237 ; 537 ; 637 ; 737 ; 837 ; 937) présentant des troisièmes distances focales et les quatrièmes lentilles cylindriques (245 ; 545 ; 645 ; 745 ; 845 ; 945) présentant des quatrièmes distances focales, le rapport largeur/distance focale des troisièmes lentilles cylindriques (237 ; 537 ; 637 ; 737 ; 837 ; 937) étant inférieur à celui des premières lentilles cylindriques (241 ; 641 ; 741 ; 841 ; 941) et/ou le rapport largeur/distance focale des quatrièmes lentilles cylindriques (245 ; 545 ; 645 ; 745 ; 845 ; 945) étant inférieur à celui des deuxièmes lentilles cylindriques (249 ; 649 ; 749 ; 849 ; 949).

7. Système d'éclairage selon la revendication 6, le rapport largeur/distance focale des troisièmes lentilles cylindriques (237 ; 537 ; 637 ; 737 ; 837 ; 937) étant au moins égal à la moitié de celui des premières lentilles cylindriques (241 ; 641 ; 741 ; 841 ; 941) et/ou le rapport largeur/distance focale des quatrièmes lentilles cylindriques (245 ; 545 ; 645 ; 745 ; 845 ; 945) étant au moins égal à la moitié de celui des deuxièmes lentilles cylindriques (249 ; 649 ; 749 ; 849 ; 949) .

8. Système d'éclairage selon l'une des revendications 1 à 7, les troisièmes lentilles cylindriques (537) étant disposées sur une surface avant et les premières lentilles cylindriques (541) sur une surface arrière d'une plaque monobloc (571) et/ou les quatrièmes lentilles cylindriques (545) étant disposées sur une surface avant et les deuxièmes lentilles cylindriques (549) sur une surface arrière d'une plaque monobloc (573).

9. Système d'éclairage selon l'une des revendications 1 à 8, le plan d'obturation (13 ; 213 ; 513 ; 613 ; 713 ; 813 ; 913) étant accessible.

**10.** Système d'éclairage selon la revendication 9, un premier dispositif d'obturation (14 ; 214 ; 514 ; 614 ; 714 ; 814 ; 914) destiné à commander un éclairage du plan d'obturation (13 ; 213 ; 513 ; 613 ; 713 ; 813 ; 913) étant disposé dans le plan d'obturation (13 ; 213 ; 513 ; 613 ; 713 ; 813 ; 913).

**11.** Système d'éclairage selon l'une des revendications 1 à 10, un deuxième dispositif d'obturation (542 ; 642) étant disposé devant ou derrière le premier réseau (571 ; 639) et/ou un troisième dispositif d'obturation (550 ; 650) étant disposé devant ou derrière le deuxième réseau (551 ; 647) pour commander un éclairage du plan d'obturation (513 ; 613).

**12.** Système d'éclairage selon l'une des revendications 1 à 11, le condenseur alvéolaire (611) présentant à proximité du plan d'obturation (613) un réseau bidimensionnel (675) de lentilles toriques (677), lesquelles présentent deux axes principaux perpendiculaires l'un à l'autre, l'un des axes principaux étant parallèle aux premiers axes de cylindre et l'autre axe principal étant parallèle aux deuxièmes axes de cylindre.

**13.** Système d'éclairage selon la revendication 12, une lentille torique (677), combinée avec une première lentille cylindrique (641) et une deuxième lentille cylindrique (649), formant un canal optique ayant un axe (669) rectiligne commun et le canal optique présentant un point focal arrière qui se trouve dans le plan d'obturation (613) ou à proximité de celui-ci.

**14.** Système d'éclairage selon la revendication 13, le canal optique présentant, dans une intersection avec un plan dont la normale est orientée en direction des premiers axes de cylindre et qui contient l'axe (669) du canal optique, un point focal avant méridional qui se trouve à l'endroit de la première lentille cylindrique (641), et le canal optique présentant, dans une intersection avec un plan dont la normale est orientée en direction des deuxièmes axes de cylindre et qui contient l'axe (669) du canal optique, un point focal avant sagittal qui se trouve à l'endroit de la deuxième lentille cylindrique (649).

**15.** Système d'éclairage selon l'une des revendications 1 à 11, le condenseur alvéolaire (11 ; 211 ; 511 ; 811 ; 911) présentant à proximité du plan d'obturation (13 ; 213 ; 513 ; 813 ; 913) un cinquième réseau unidimensionnel (155 ; 255 ; 555 ; 855 ; 955) de cinquièmes lentilles cylindriques (257 ; 557 ; 857 ; 957) ayant des cinquièmes axes de cylindre, les cinquièmes axes de cylindre étant orientés parallèlement aux deuxièmes axes de cylindre.

**16.** Système d'éclairage selon la revendication 15, les cinquièmes lentilles cylindriques (257 ; 557 ; 857 ; 957), combinées avec une première lentille cylindrique (241 ; 541 ; 841 ; 941) et une deuxième lentille cylindrique (249 ; 549 ; 849 ; 949), formant un axe optique ayant un axe commun (269 ; 569 ; 869 ; 969), et le canal optique présentant, dans une intersection avec un plan dont la normale est orientée en direction des deuxièmes axes de cylindre et qui contient l'axe (269 ; 569 ; 869 ; 969) du canal optique, un point focal arrière sagittal qui se trouve dans le plan d'obturation (213 ; 513 ; 813 ; 913) où à proximité de celui-ci.

**17.** Système d'éclairage selon la revendication 16, le canal optique présentant, dans une intersection avec un plan dont la normale est orientée en direction des deuxièmes axes de cylindre (249 ; 549 ; 849 ; 949) et qui contient l'axe (269 ; 569 ; 869 ; 969) du canal optique, un point focal avant sagittal qui se trouve à l'endroit de la deuxième lentille cylindrique (249 ; 549 ; 849 ; 949).

**18.** Système d'éclairage selon la revendication 16 ou 17, le canal optique présentant, dans une intersection avec un plan dont la normale est orientée en direction des deuxièmes axes de cylindre et qui contient l'axe (269 ; 569 ; 869) du canal optique, un point focal arrière méridional qui se trouve dans le plan d'obturation (213 ; 513 ; 813) où à proximité de celui-ci.

**19.** Système d'éclairage selon la revendication 16 ou 17, le canal optique présentant, dans une intersection avec un plan dont la normale est orientée en direction des deuxièmes axes de cylindre (941) et qui contient l'axe (969) du canal, un point focal arrière méridional et une distance focale méridionale, l'écart entre le plan d'obturation (913) et le point focal arrière méridional étant quasiment égal à la moitié de la distance focale méridionale.

**20.** Système d'éclairage selon la revendication 15, le condenseur alvéolaire (11 ; 211 ; 511) présentant un sixième réseau unidirectionnel (251 ; 551) de sixièmes lentilles cylindriques (253 ; 553) ayant des sixièmes axes de cylindre à proximité du plan d'obturation (13 ; 213 ; 513), les sixièmes axes de cylindre étant orientés parallèlement aux premiers axes de cylindre.

**21.** Système d'éclairage selon la revendication 20, une sixième lentille cylindrique (253 ; 553), combinée avec une cinquième lentille cylindrique (257 ; 557), une deuxième lentille cylindrique (249 ; 549) et une première lentille cylindrique (241 ; 541), formant un canal optique ayant un axe (269 ; 569) rectiligne commun et le canal optique présentant un point focal arrière qui se trouve dans le plan d'obturation (213 ; 513) ou à proximité de celui-ci.

**22.** Système d'éclairage selon la revendication 21, le canal optique présentant, dans une intersection avec un plan dont la normale est orientée en direction des premiers axes de cylindre et qui contient l'axe (269 ; 569) du canal optique, un point focal avant méridional qui se trouve à l'endroit de la première lentille cylindrique (241 ; 541), et le canal optique présentant, dans une intersection avec un plan dont la normale est orientée en direction des deuxièmes axes de cylindre et qui contient l'axe (269 ; 569) du canal optique, un point focal avant sagittal qui se trouve à l'endroit de la deuxième lentille cylindrique (249 ; 549).

**23.** Système d'éclairage selon l'une des revendications 20 à 22, les premières lentilles cylindriques (241 ; 541), les deuxièmes lentilles cylindriques (249 ; 549), les cinquièmes lentilles cylindriques (257 ; 557) et les sixièmes lentilles cylindriques (253 ; 553) présentant la même largeur.

**24.** Système d'éclairage selon la revendication 23, le condenseur alvéolaire (211), combiné avec le troisième réseau (235) et le quatrième réseau (243) éclairant le plan d'obturation (213), l'éclairage (400) du plan d'obturation présentant des premières bandes non éclairées (406) en direction des premiers axes de cylindre, et la largeur des premières bandes (406) étant égale au maximum à 20 % de la première largeur, et l'éclairage du plan d'obturation présentant des deuxièmes bandes non éclairées (404) en direction des deuxièmes axes de cylindre à un écart égal à la deuxième largeur, et la largeur des deuxièmes bandes (404) étant égale au maximum à 20 % de la deuxième largeur.

**25.** Système d'éclairage selon la revendication 24, la largeur des premières bandes (406) étant égale à la largeur des deuxièmes bandes (404).

**26.** Système d'éclairage selon l'une des revendications 20 à 25, les cinquièmes lentilles cylindriques (257 ; 557) étant disposées sur une surface avant et les sixièmes lentilles cylindriques (253 ; 553) sur une surface arrière d'une plaque monobloc (779).

**27.** Système d'éclairage d'un équipement d'exposition par projection pour microlithographie comprenant

  - une source de lumière (1),
  - un premier objectif (3, 5, 7),
  - un condenseur alvéolaire (11 ; 811 ; 911) qui est éclairé par le premier objectif (3, 5, 7), génère une pluralité de faisceaux de lignes et

   * comprend un premier réseau unidimensionnel (839 ; 939) de premières lentilles cylindriques (841 ; 941) ayant des premiers axes de cylindre ainsi que
   * un deuxième réseau unidimensionnel (847 ; 947) de deuxièmes lentilles cylindriques (849 ; 949) ayant des deuxièmes axes de cylindre, les deuxièmes axes de cylindre étant dirigés perpendiculairement par rapport aux premiers axes de cylindre,

  - un plan d'obturation (13 ; 813 ; 913) directement après le condenseur alvéolaire (11 ; 811 ; 911),
  - une optique de condenseur (15 ; 815 ; 915) qui superpose les faisceaux de lignes générés par le condenseur alvéolaire (11 ; 811 ; 911) dans un plan d'image (19 ; 819 ; 919) afin d'éclairer un champ,

**caractérisé en ce que**
l'équipement d'exposition par projection pour microlithographie est un scanner avec un sens de balayage et le condenseur alvéolaire (11 ; 811 ; 911) présente à proximité du plan d'obturation (13 ; 813 ; 913) un cinquième réseau unidimensionnel (855 ; 955) de cinquièmes lentilles cylindriques (857 ; 957) ayant des cinquièmes axes de cylindre, et les cinquièmes axes de cylindre sont orientés parallèlement aux deuxièmes axes de cylindre et perpendiculairement au sens de balayage.

**28.** Système d'éclairage selon la revendication 27, une cinquième lentille cylindrique (857 ; 957), combinée avec une première lentille cylindrique (841 ; 941) et une deuxième lentille cylindrique (849 ; 949), formant un canal optique ayant un axe (869 ; 969) commun et le canal optique présentant, dans une intersection avec un plan dont la normale est orientée en direction des deuxièmes axes de cylindre et qui contient l'axe (869 ; 969) du canal optique, un point focal arrière sagittal qui se trouve dans le plan d'obturation (813 ; 913) où à proximité de celui-ci.

**29.** Système d'éclairage selon la revendication 28, le canal optique présentant, dans une intersection avec un plan dont la normale est orientée en direction des deuxièmes axes de cylindre et qui contient l'axe (869 ; 969) du canal optique, un point focal avant sagittal qui se trouve à l'endroit de la deuxième lentille cylindrique (849 ; 949).

**30.** Système d'éclairage selon la revendication 28 ou 29, **caractérisé en ce que** le canal optique présente, dans une intersection avec un plan dont la normale est orientée en direction des premiers axes de cylindre et qui contient l'axe (869) du canal, un point focal arrière méridional qui se trouve dans le plan d'obturation (813) où à proximité de celui-ci.

**31.** Système d'éclairage selon la revendication 28 ou 29, le canal optique présentant, dans une intersection avec un plan dont la normale est orientée en direction des premiers axes de cylindre et qui contient l'axe (969) du canal, un point focal arrière méridional et une distance focale méridionale, l'écart entre le plan d'obturation (913) et le point focal arrière méridional étant quasiment égal à la moitié de la distance focale méridionale.

**32.** Système d'éclairage selon l'une des revendications 27 à 31, **caractérisé en ce qu'**un troisième réseau unidimensionnel (835 ; 935) de troisièmes lentilles cylindriques (837 ; 937) ayant des troisièmes axes de cylindre augmentant une divergence est disposé devant le premier réseau (839 ; 939), les troisièmes axes de cylindre étant orientés parallèlement aux premiers axes de cylindre.

**33.** Système d'éclairage selon l'une des revendications 27 à 32, **caractérisé en ce qu'**un quatrième réseau unidimensionnel (843 ; 943) de quatrièmes lentilles cylindriques (845 ; 945) ayant des quatrièmes axes de cylindre augmentant une divergence est disposé devant le deuxième réseau (847 ; 947), les quatrièmes axes de cylindre étant orientés parallèlement aux deuxièmes axes de cylindre.

**34.** Équipement d'exposition par projection pour microlithographie

- comprenant un système d'éclairage (1, 3, 5, 7, 9, 11, 13, 14, 15, 17, 19, 21, 23, 25) selon l'une des revendications 1 à 33,
- comprenant un masque (27) sur un premier système support,
- comprenant un objectif de projection (29),
- comprenant un substrat photosensible (33) sur un deuxième système support.

**35.** Procédé pour fabriquer des composants microstructurés, avec lequel un substrat (33) muni d'une couche photosensible est éclairé au moyen d'un masque (27) et d'un équipement d'exposition par projection pour microlithographie selon la revendication 34 puis structuré par représentation d'un motif présent sur le masque (27).

FIG.1

# FIG.2

FIG.3

301  303  305  307  309  311

302  304  306  308  310  312

EP 1 180 726 B1

# FIG.4

## FIG.5

## FIG.6

617
611
615
669
637
641
609 635 639 643 647 675 613 0A 619 621
642
650
645 649 677
677
614
669
611
615
617

y

z

x

z

## FIG.7

717

711

715

769

737   741

709  735   739   743   747   753   779   713  0A  719   721

714

745   749   757

769

711

715

717

_FIG.8_

## FIG.9